# EUROPEAN PATENT APPLICATION

(11) **EP 4 815 694 A1**
(43) Date of publication of application: **30.09.2026**
(21) Application number: 26165977.5
(22) Date of filing: 19.03.2026
(51) Int. Cl.: H10K 59/121, H10K 59/123, H10K 59/131, H10K 59/80

(54) **DISPLAY DEVICES AND ELECTRONIC DEVICES INCLUDING THE SAME**

(30) Priority: 24.03.2025 KR 20250037096
(71) Applicant: Samsung Display Co., Ltd., Yongin-si, Gyeonggi-do 17113 (KR)
(72) Inventor: Kim, Minjoo, 17113 Yongin-si, Gyeonggi-do (KR); Min, Junyoung, 17113 Yongin-si, Gyeonggi-do (KR); Byun, Minwoo, 17113 Yongin-si, Gyeonggi-do (KR)
(74) Representative: Gulde & Partner

(57) **Abstract**

A display device include: a substrate, a pixel driving circuit on the substrate and including a transistor, a connection electrode on the substrate and electrically connected to the pixel driving circuit, a first electrode on the substrate and spaced apart from the connection electrode, a pixel defining layer on the substrate, the pixel defining layer defining an opening exposing a portion of the first electrode, an electrode layer on the first electrode and electrically connected to the connection electrode, a first driving voltage line in a same layer as the first electrode and configured to receive a first power voltage, the first driving voltage line extending in a first direction, and a second driving voltage line in the same layer as the first electrode and configured to receive the first power voltage, the second driving voltage line extending in a second direction intersecting the first direction.

## Description

### BACKGROUND

### 1. FIELD

The present disclosure relates generally to a display device. More particularly, the present disclosure relates to a display device and an electronic device including the display device.

### 2. DESCRIPTION OF THE RELATED ART

With the development of information technology, the importance of display devices, which provide a connection medium between a user and information, has been highlighted. For example, the use of display devices such as liquid crystal display (LCD) devices, organic light emitting diode (OLED) display devices, plasma display panel (PDP) devices, quantum dot display devices, or the like, is increasing.

Display devices include a light-emitting element and a pixel driving circuit for driving the light-emitting element. The light-emitting element is driven by the pixel driving circuit to emit light.

### SUMMARY

Some example embodiments provide a display device with improved display quality. Some example embodiments provide for improved reliability of the display device.

Some example embodiments provide an electronic device including the display device.

A display device according to some example embodiments of the present disclosure includes a substrate, a pixel driving circuit on the substrate, the pixel driving circuit including a transistor, the transistor including a driving transistor, a connection electrode on the substrate, the connection electrode being electrically connected to the pixel driving circuit, a first electrode on the substrate, the first electrode being spaced apart from the connection electrode, a pixel defining layer on the substrate, the pixel defining layer defining an opening exposing a portion of the first electrode, an electrode layer on the first electrode, the electrode layer being electrically connected to the connection electrode, a first driving voltage line in a same layer as the first electrode, the first driving voltage line being configured to receive a first power voltage, and the first driving voltage line extending in a first direction, and a second driving voltage line in the same layer as the first electrode, the second driving voltage line being configured to receive the first power voltage, and the second driving voltage line extending in a second direction intersecting the first direction. The first and second directions may refer to the first and second diagonal directions defined in the DETAILED DESCRIPTION, respectively.

The display device may include a light-emitting element, which includes the first electrode and the electrode layer. The connection electrode may be spaced apart from the first electrode. The electrode layer may be a cathode and the first electrode may be an anode.

In some example embodiments, the first driving voltage line and the second driving voltage line may have a mesh shape in a plan view.

In some example embodiments, the display device may include a third driving voltage line between the substrate and the first electrode, the third driving voltage line being configured to receive the first power voltage, and a fourth driving voltage line between the third driving voltage line and the first electrode, the fourth driving voltage line being configured to receive the first power voltage.

In some example embodiments, the third driving voltage line and the fourth driving voltage line may have a mesh shape in a plan view.

In some example embodiments, the display device may include a separator on the pixel defining layer, and the separator being configured to separate the electrode layer into a plurality of second electrodes spaced apart from each other, and a connection pattern on the connection electrode and the pixel defining layer, the connection pattern being connected to the connection electrode. The electrode layer and the first electrode may be connected to a drain of the driving transistor of the pixel driving circuit through the connection electrode CE and the connection pattern.

In some example embodiments, the connection pattern may be connected to one among the plurality of second electrodes at a position adjacent to or overlapping the separator.

In some example embodiments, the display device may include a driving voltage connection pattern in the same layer as the first electrode, the driving voltage connection pattern electrically connecting the first driving voltage line and the fourth driving voltage line.

In some example embodiments, the connection pattern may be connected to the connection electrode through a pattern contact hole, the driving voltage connection pattern may be connected to the fourth driving voltage line through a driving contact hole, and the pattern contact hole and the driving contact hole may be spaced apart from each other in a plan view.

In some example embodiments, the pixel driving circuit may include a lower active pattern on the substrate, a first gate electrode on the lower active pattern, and a contact electrode on the first gate electrode.

In some example embodiments, the third driving voltage line and the contact electrode may be in a same layer, and the fourth driving voltage line and the connection electrode may be in a same layer.

In some example embodiments, the first driving voltage line, the second driving voltage line, and the first electrode may be integrally formed.

A display device according to some example embodiments of the present disclosure includes a substrate, a pixel driving circuit on the substrate, the pixel driving circuit including a transistor, a connection electrode on the substrate, the connection electrode being electrically connected to the pixel driving circuit, a first electrode on the substrate, the first electrode being spaced apart from the connection electrode, a pixel defining layer on the substrate, the pixel defining layer defining an opening exposing a portion of the first electrode, an electrode layer on the first electrode, the electrode layer being electrically connected to the connection electrode, a first initialization voltage line between the substrate and the first electrode, the first initialization voltage line being configured to receive an initialization voltage, and the first initialization voltage line extending in a first direction, a second initialization voltage line between the first initialization voltage line and the first electrode, the second initialization voltage line being configured to receive the initialization voltage, and the second initialization voltage line extending in a second direction intersecting the first direction, a first driving voltage line in a same layer as the first electrode, the first driving voltage line being configured to receive a first power voltage, and the first driving voltage line extending in a first diagonal direction between the first direction and the second direction, and a second driving voltage line in the same layer as the first electrode, the second driving voltage line being configured to receive the first power voltage, and the second driving voltage line extending in a second diagonal direction intersecting the first diagonal direction.

In some example embodiments, the first driving voltage line and the second driving voltage line may have a mesh shape in a plan view, and the first initialization voltage line and the second initialization voltage line may have a mesh shape in the plan view.

In some example embodiments, the display device may include a third driving voltage line between the substrate and the first electrode, the third driving voltage line being configured to receive the first power voltage, and the third driving voltage line extending in the first direction, and a fourth driving voltage line between the third driving voltage line and the first electrode, the fourth driving voltage line being configured to receive the first power voltage, and the fourth driving voltage line extending in the second direction.

In some example embodiments, the display device may include an initialization voltage connection pattern electrically connecting the first initialization voltage line and the second initialization voltage line, the fourth driving voltage line may be connected to the third driving voltage line through a first driving contact hole, the second initialization voltage line may be connected to the initialization voltage connection pattern through an initialization contact hole, and the first driving contact hole and the initialization contact hole may be spaced apart from each other in a plan view.

In some example embodiments, the first driving contact hole and the initialization contact hole may be alternately arranged along one direction in the plan view.

In some example embodiments, the display device may include a driving voltage connection pattern in the same layer as the first electrode, the driving voltage connection pattern electrically connecting the first driving voltage line and the fourth driving voltage line, the driving voltage connection pattern may be connected to the fourth driving voltage line through a second driving contact hole, and the first driving contact hole and the second driving contact hole may be spaced apart from each other in the plan view.

In some example embodiments, the third driving voltage line may be on the first initialization voltage line, and the fourth driving voltage line and the second initialization voltage line may be in a same layer.

In some example embodiments, the first driving voltage line, the second driving voltage line, and the first electrode may be integrally formed.

An electronic device according to some example embodiments of the present disclosure includes a display device including a pixel, and processing circuitry configured to transmit an image data signal and an input control signal to the display device, wherein the display device includes, a substrate, a pixel driving circuit on the substrate, the pixel driving circuit including a transistor, a connection electrode on the substrate, the connection electrode being electrically connected to the pixel driving circuit, a first electrode on the substrate, the first electrode being spaced apart from the connection electrode, a pixel defining layer on the substrate, the pixel defining layer defining an opening exposing a portion of the first electrode, an electrode layer on the first electrode, the electrode layer being electrically connected to the connection electrode, a first driving voltage line in a same layer as the first electrode, the first driving voltage line being configured to receive a first power voltage, and the first driving voltage line extending in a first direction, and a second driving voltage line in the same layer as the first electrode, the second driving voltage line being configured to receive the first power voltage, and the second driving voltage line extending in a second direction intersecting the first direction.

A display device according to some example embodiments of the present disclosure may include a light-emitting element including a first electrode and an electrode layer disposed on the first electrode, a connection electrode spaced apart from the first electrode, a connection pattern disposed on the connection electrode, and a separator that separates the electrode layer into a plurality of second electrodes spaced apart from each other. The electrode layer (e.g., a cathode) disposed on the first electrode (e.g., an anode) may be connected to a drain of a driving transistor of the pixel driving circuit through the connection electrode and the connection pattern. Accordingly, a gate-source voltage (Vgs) of the driving transistor may not change even when a light-emitting element deteriorates. Accordingly, a range of change in a driving current due to the deterioration of the light-emitting element may be reduced. Accordingly, afterimage defects of the display device due to increased usage time may be reduced, and the lifetime of the display device may be improved (e.g., increased).

In addition, according to some example embodiments, the display device may further include a first driving voltage line and a second driving voltage line that are disposed in the same layer as the first electrode, and receive a first power voltage. The first driving voltage line may extend in a first direction, and the second driving voltage line may extend in a second direction intersecting the first direction. That is, the first driving voltage line and the second driving voltage line may have a mesh shape in a plan view. Accordingly, a resistance generated in lines that transmit the first power voltage may be effectively reduced, and the voltage drop of the first power voltage may be effectively prevented (or reduced).

### BRIEF DESCRIPTION OF THE DRAWINGS

Illustrative, non-limiting examples will be more clearly understood from the following detailed description in conjunction with the accompanying drawings.
FIG. 1 is a block diagram illustrating a display device according to some example embodiments of the present disclosure.
FIG. 2A is a plan view illustrating an example of the display device of FIG. 1.
FIG. 2B is a plan view illustrating another example of the display device of FIG. 1.
FIG. 3A is a circuit diagram illustrating an example of a circuit structure of a pixel included in the display device of FIG. 1.
FIG. 3B is a timing diagram illustrating an example of the display device of FIG. 1 performing an address scan operation on the pixel of FIG. 3A.
FIG. 3C is a timing diagram illustrating an example of the display device of FIG. 1 performing a self-scan operation on the pixel of FIG. 3A.
FIG. 3D is a circuit diagram illustrating another example of a circuit structure of a pixel included in the display device of FIG. 1.
FIG. 3E is a timing diagram illustrating an example of the display device of FIG. 1 performing an address scan operation on the pixel of FIG. 3D.
FIG. 4A is a circuit diagram illustrating still another example of a circuit structure of a pixel included in the display device of FIG. 1.
FIG. 4B is a timing diagram illustrating an example of the display device of FIG. 1 performing an address scan operation on the pixel of FIG. 4A.
FIG. 5A is a circuit diagram illustrating still another example of a circuit structure of a pixel included in the display device of FIG. 1.
FIG. 5B is a timing diagram illustrating an example of the display device of FIG. 1 performing an address scan operation on the pixel of FIG. 5A.
FIG. 6 is a plan view schematically illustrating a portion of an area of the display device of FIGS. 2A and 2B.
FIG. 7 is a cross-sectional view taken along the line I-I' of FIG. 6.
FIGS. 8, 9, 10, 11, 12, 13, 14, 15, 16, 17, 18, 19, and 20 are layout views illustrating an example of a pixel included in the display device of FIG. 1.
FIG. 21 is a layout view illustrating a pixel layer in which a first electrode of FIG. 7 is disposed.
FIG. 22 is a layout view in which the pixel layer of FIG. 21 is further disposed on a fifth conductive layer of FIG. 19.
FIG. 23 is a block diagram illustrating an electronic device according to some example embodiments of the present disclosure.
FIG. 24 is a schematic view of an electronic device according to some example embodiments.

### DETAILED DESCRIPTION

Some example embodiments will be described more fully hereinafter with reference to the accompanying drawings, in which some example embodiments are shown. The present inventive concepts may, however, be embodied in many different forms and should not be construed as limited to the examples set forth herein. Rather, these examples are provided so that this disclosure will be thorough and complete, and will fully convey the scope of the present inventive concepts to those skilled in the art. In the drawings, the sizes and relative sizes of layers and areas may be exaggerated for clarity.

In the disclosure, various modifications may be made, various forms may be used, and specific examples will be illustrated in the drawings and described in detail in the text. However, this is not intended to limit the disclosure to a specific form disclosed, and it will be understood that all changes, equivalents, or substitutes which fall in the scope of the disclosure should be included.

It will be understood that, although the terms first, second, third, etc., may be used herein to describe various elements, these elements should not be limited by these terms. These terms are used to distinguish one element from another. Thus, a first element discussed below could be termed a second element without departing from the teachings of the present inventive concepts. As used herein, the term "and/or" includes any and all combinations of one or more of the associated listed items.

It will be understood that when an element is referred to as being "connected" or "coupled" to another element, the element may be directly connected or coupled to the other element or intervening element(s) may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular examples only and is not intended to be limiting of the present inventive concepts. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, operations, elements, and/or components, but do not preclude the presence or addition of one or more other features, integers, operations, elements, components, and/or groups thereof.

Furthermore, relative terms, such as "lower" or "bottom," and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," may therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" may, therefore, encompass both an orientation of above and below.

Unless otherwise defined, all terms (including technical and scientific terms) used herein have the same meaning as, or a similar meaning to, that commonly understood by one of ordinary skill in the art to which the inventive concepts belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

Hereinafter, some example embodiments will be described in detail with reference to the accompanying drawings. The same reference numerals (or similar reference numerals) are used for the same components (or similar components) in the drawings, and redundant descriptions of the same components (or similar components) will be omitted.

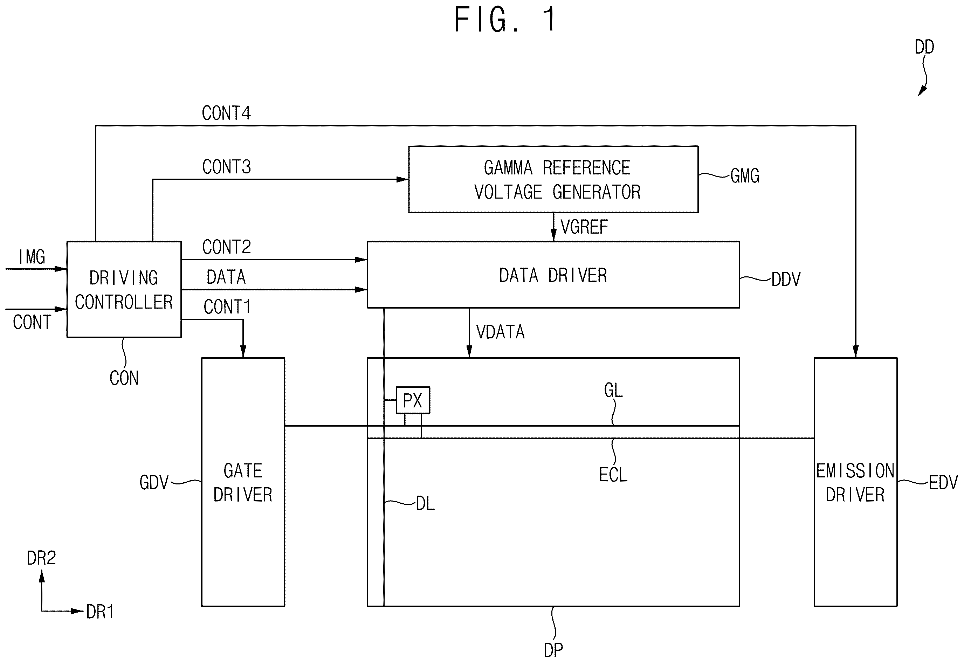

FIG. 1 is a block diagram illustrating a display device according to some example embodiments of the present disclosure.

Referring to FIG. 1, a display device DD according to some example embodiments of the present disclosure may include a display panel DP and a panel driver that drives the display panel DP. The panel driver may include a driving controller CON, a gate driver GDV, a gamma reference voltage generator GMG, a data driver DDV, and/or an emission driver EDV. According to some example embodiments, operations described herein as being performed by the display device DD, the display panel DP, the panel driver, the driving controller CON, the gate driver GDV, the gamma reference voltage generator GMG, the data driver DDV, and/or the emission driver EDV may be performed by processing circuitry. The term 'processing circuitry,' as used in the present disclosure, may refer to, for example, hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), a digital signal processor, a microcomputer, a field programmable gate array (FPGA), a System-on-Chip (SoC), a programmable logic unit, a microprocessor, application-specific integrated circuit (ASIC), etc.

For example, the driving controller CON and the data driver DDV may be integrally formed. A driving module in which the driving controller CON and the data driver DDV are integrally formed may be referred to as a timing controller embedded data driver (TED).

The display panel DP may include gate lines GL, emission control lines ECL, data lines DL, and pixels PX. The pixels PX may be electrically connected to the gate lines GL, the emission control lines ECL, and the data lines DL. Each of the pixels PX may generate light in response to a driving signal. For example, each of the gate lines GL may extend in a first direction DR1, and each of the emission control lines ECL may extend in the first direction DR1. Each of the data lines DL may extend in a second direction DR2 intersecting the first direction DR1. For example, the first direction DR1 and the second direction DR2 may be perpendicular to each other.

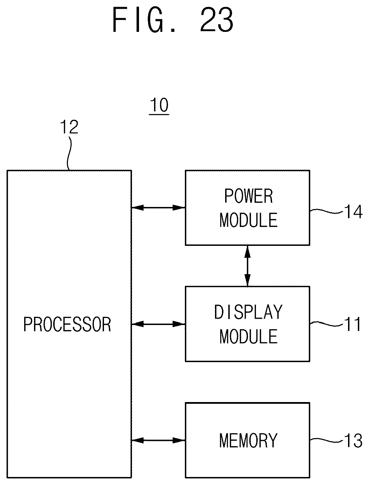

The driving controller CON may receive an image data signal IMG and an input control signal CONT from an external device (e.g., a processor 12 of FIG. 23). For example, the image data signal IMG may include red image data, green image data, and blue image data. In some example embodiments, the image data signal IMG may further include white image data. The input control signal CONT may include a vertical synchronization signal, a horizontal synchronization signal, a data enable signal, a master clock signal, or the like.

The driving controller CON may generate a first control signal CONT1, a second control signal CONT2, a third control signal CONT3, a fourth control signal CONT4, and a data signal DATA based on the image data signal IMG and the input control signal CONT.

The driving controller CON may output the first driving signal CONT1 to the gate driver GDV. The first control signal CONT1 may include a vertical start signal and a gate clock signal. The driving controller CON may output the second control signal CONT2 and the data signal DATA to the data driver DDV. The second control signal CONT2 may include a horizontal start signal and a load signal. The driving controller CON may output the third control signal CONT3 to the gamma reference voltage generator GMG. The driving controller CON may output the fourth driving signal CONT4 to the emission driver EDV.

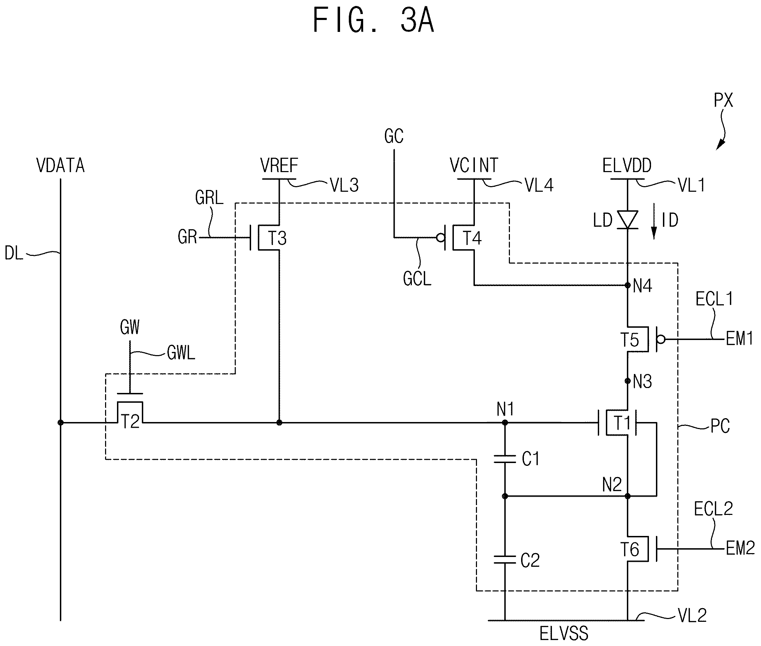

The gate driver GDV may generate gate signals in response to the first control signal CONT1. The gate driver GDV may output the gate signals to the gate lines GL. In some example embodiments, the gate signals may include first to third gate signals GW, GR, and GC illustrated in FIGS. 3A, 3D, 4A, and 5A. However, the present disclosure is not necessarily limited thereto.

The gamma reference voltage generator GMG may generate a gamma reference voltage VGREF in response to the third control signal CONT3. The gamma reference voltage generator GMG may provide the gamma reference voltage VGREF to the data driver DDV. For example, the gamma reference voltage generator GMG may be disposed in the driving controller CON, or may be disposed in the data driver DDV.

The data driver DDV may receive the second control signal CONT2 and the data signal DATA from the driving controller CON, and may receive the gamma reference voltage VGREF from the gamma reference voltage generator GMG. The data driver DDV may convert the data signal DATA into an analog form of a data voltage VDATA using the gamma reference voltage VGREF. The data driver DDV may output the data voltage VDATA to the data lines DL.

The emission driver EDV may generate emission signals in response to the fourth control signal CONT4. The emission driver EDV may output the emission signals to the emission control lines ECL. In some example embodiments, the emission signals may include a first emission control signal EM1 and a second emission control signal EM2 illustrated in FIGS. 3A, 3D, 4A, and 5A. However, the present disclosure is not necessarily limited thereto.

In FIG. 1, for convenience of description, the gate driver GDV is illustrated as being disposed at a first side of the display panel DP and the emission driver EDV is illustrated as being disposed at a second side opposite to the first side of the display panel DP, but the present disclosure is not necessarily limited thereto. For example, both the gate driver GDV and the emission driver EDV may be disposed at the first side of the display panel DP. For another example, both the gate driver GDV and the emission driver EDV may be disposed at opposite sides of the display panel DP. For still another example, the gate driver GDV and the emission driver EDV may be integrally formed.

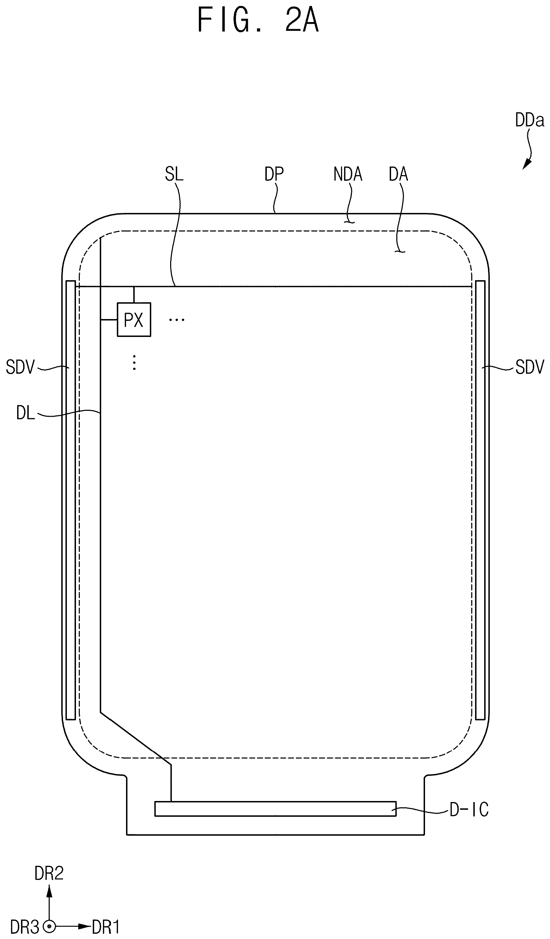

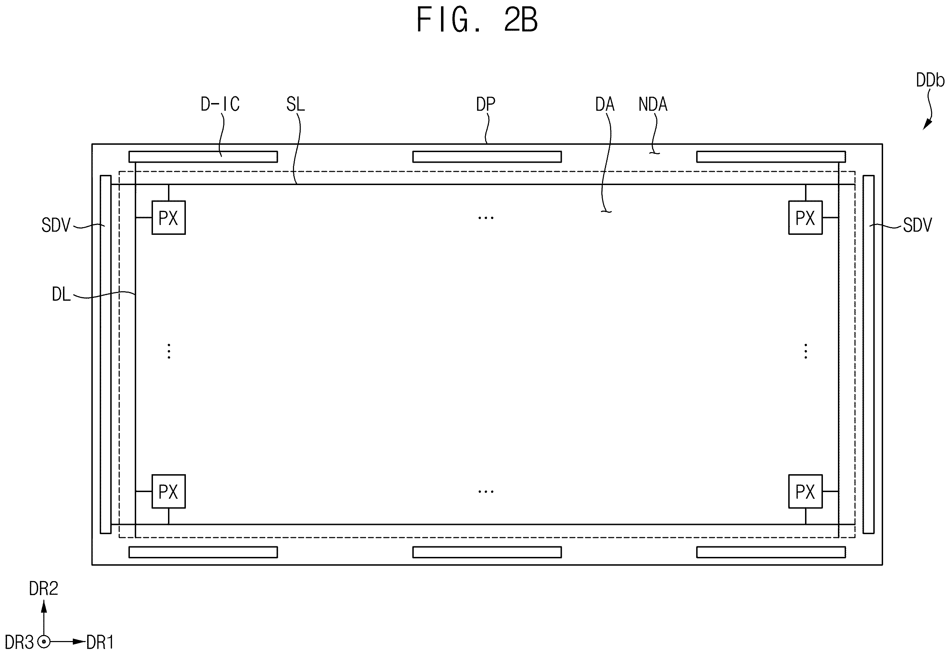

FIG. 2A is a plan view illustrating an example of the display device of FIG. 1. FIG. 2B is a plan view illustrating another example of the display device of FIG. 1.

In this specification, a plane may be defined by the first direction DR1 and the second direction DR2, and a direction normal to the plane may be a third direction DR3. In other words, the third direction DR3 may be perpendicular to each of the first direction DR1 and the second direction DR2. As used herein the "plan view" is a view in the third direction DR3.

Referring to FIGS. 2A and 2B, each of display devices DDa and DDb may be a device that is activated in response to an electrical signal. For example, the display device DDa may be a small display device used in small electronic devices such as a smartphone, a cell phone, a smart watch, a gaming console, a camera, etc. In addition, the display device DDb may be a medium- to large-sized display device used for medium- to large-sized electronic devices, such as a laptop, a tablet Personal Computer (PC), a television, a computer monitor, a in-vehicle monitor, an exterior billboard, etc. In FIG. 2A, the display device DDa is illustrated as an example of the small display device, and in FIG. 2B, the display device DDb is illustrated as an example of the medium- to large-sized display device.

Each of the display devices DDa and DDb may include a display area DA and a peripheral area NDA. The display area DA may be an area that displays an image by generating light or adjusting the transmittance of light provided from an external light source. The peripheral area NDA may be adjacent to the display area DA. The peripheral area NDA may surround at least a portion of the display area DA in a plan view. For example, the peripheral area NDA may entirely surround the display area DA in a plan view. In some example embodiments, the peripheral area NDA may be an area that does not display an image. However, the present disclosure is not necessarily limited thereto, and an image may be displayed in at least a portion of the peripheral area NDA.

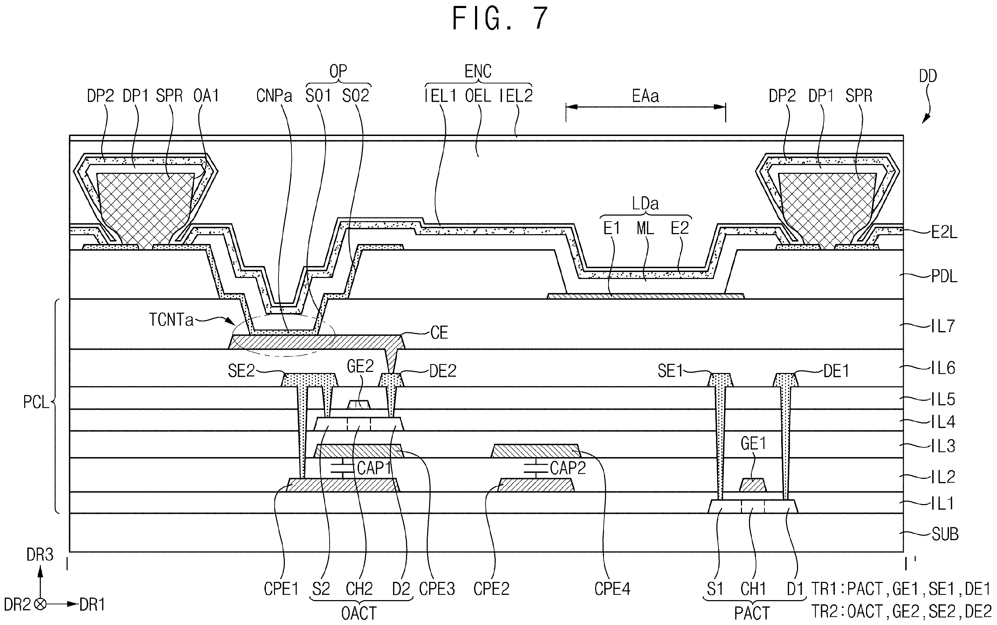

Each of the display devices DDa and DDb may include the display panel DP, a scan driver SDV, and a driving chip D-IC, and the display panel DP may include a substrate (SUB, see FIG. 7), the pixels PX, scan lines SL, and/or the data lines DL. According to some example embodiments, operations described herein as being performed by each of the display devices DDa and DDb, the display panel DP, the scan driver SDV, and/or a driving chip D-IC may be performed by processing circuitry.

The substrate may form a base of each of the display devices DDa and DDb. Examples of materials that may be used as the substrate may include glass, quartz, silicon, polymer, or the like. These may be used alone or in combination with each other.

The pixels PX may be disposed in the display area DA on the substrate. The pixels PX may be electrically connected to the scan line SL and the data line DL. The scan line SL may correspond to the gate line GL or the emission control line ECL of FIG. 1.

Each of the pixels PX may include a plurality of sub-pixels. For example, each of the pixels PX may include a first sub-pixel, a second sub-pixel, and a third sub-pixel. Each of the first to third sub-pixels may include a light-emitting element and a pixel driving circuit connected to the light-emitting element. The light-emitting element may emit light. In some example embodiments, the first to third sub-pixels may emit light of different wavelength bands. That is, the first to third sub-pixels may emit light of different colors. For example, the first sub-pixel may emit red light, the second sub-pixel may emit green light, and the third sub-pixel may emit blue light. However, the present disclosure is not necessarily limited thereto.

The driving chip D-IC may be disposed in the peripheral area NDA on the substrate. The driving chip D-IC may correspond to the data driver DDV of FIG. 1. That is, the driving chip D-IC may output the data voltage (VDATA, see FIG. 1) to the data line DL. The data voltage may be applied to the pixels PX through the data line DL.

In some example embodiments, the driving chip D-IC may be mounted on the substrate. However, the present disclosure is not necessarily limited thereto, and the driving chip D-IC may be disposed on a flexible film bonded to the substrate in the form of a chip on film (COF).

In some example embodiments, the display device DDb of FIG. 2B may include a plurality of driving chips D-IC. For example, the driving chips D-IC may be disposed at opposite sides of the display area DA in the second direction DR2. For example, the driving chips D-IC may be disposed along a long side of the display device DDb. However, the present disclosure is not necessarily limited thereto.

The scan driver SDV may be disposed in the peripheral area NDA on the substrate. The scan driver SDV may correspond to the gate driver GDV or the emission driver EDV of FIG. 1. For example, the scan driver SDV may output the gate signal to the scan line SL. The gate signal may be applied to the pixels PX through the scan line SL. For example, the scan driver SDV may output the emission signal to the scan line SL. The emission signal may be applied to the pixels PX through the scan line SL.

In some example embodiments, the scan driver SDV may be disposed at opposite sides of the display area DA in the first direction DR1. However, the present disclosure is not necessarily limited thereto.

The number or arrangement relationship of the driving chip D-IC and the number or arrangement relationship of the scan driver SDV illustrated in FIGS. 2A and 2B are merely examples, and the present disclosure is not necessarily limited thereto.

In addition, although the display device DDa in FIG. 2A is illustrated as having a substantially rectangular planar shape having a short side extending in the first direction DR1 and a long side extending in the second direction DR2, the present disclosure is not necessarily limited thereto. In addition, although the display device DDb in FIG. 2B is illustrated as having a substantially rectangular planar shape having a long side extending in the first direction DR1 and a short side extending in the second direction DR2, the present disclosure is not necessarily limited thereto. That is, the planar shape of each of the display devices DDa and DDb may be variously changed according to some example embodiments.

The descriptions referring to the following drawings may be equally (or similarly) applied to the display device DDa of FIG. 2A and the display device DDb of FIG. 2B. Hereinafter, for convenience of description, the expression (e.g., the display device DDa of FIG. 2A and the display device DDb of FIG. 2B) will be unified as the display device DD.

FIG. 3A is a circuit diagram illustrating an example of a circuit structure of a pixel included in the display device of FIG. 1. For example, FIG. 3A may be a circuit diagram of any one of the first to third sub-pixels included in the pixel PX.

Referring to FIG. 3A, the pixel PX may include a light-emitting element LD and a pixel driving circuit PC connected to the light-emitting element LD. In some example embodiments, the pixel driving circuit PC may include first to six transistors T1, T2, T3, T4, T5, and T6, a first capacitor C1, and a second capacitor C2. Each of the first to sixth transistors T1, T2, T3, T4, T5, and T6 may be a Metal Oxide Semiconductor Field Effect Transistor (MOSFET) formed by a semiconductor process.

In FIG. 3A, the fourth transistor T4 and the fifth transistor T5 are illustrated as p-type transistors, and the first to third transistors T1, T2, and T3, and the sixth transistor T6 are illustrated as n-type transistors. However, the present disclosure is not necessarily limited thereto, and the first to sixth transistors T1, T2, T3, T4, T5, and T6 may be n-type transistors.

When the pixel PX includes an n-type transistor and a p-type transistor, an active pattern of the n-type transistor may include an oxide semiconductor material, and an active pattern of the p-type transistor may include a silicon semiconductor material. However, the present disclosure is not necessarily limited thereto, and both the active pattern of the n-type transistor and the active pattern of the p-type transistor may include a silicon semiconductor material.

In the case of a p-type transistor, the transistor may be turned off when a gate signal has a high level of voltage (hereinafter referred to as a high gate voltage), and may be turned on when the gate signal has a low level of voltage (hereinafter referred to as a low gate voltage). That is, the high gate voltage may have a relatively high voltage level, and the low gate voltage may have a relatively low voltage level. In contrast, in the case of an n-type transistor, the transistor may be turned off when a gate signal has the low gate voltage, and may be turned on when the gate signal has the high gate voltage.

The pixel driving circuit PC may be connected to first to third gate lines GWL, GRL, and GCL, the data line DL, first to fourth voltage lines VL1, VL2, VL3, and VL4), a first emission control line ECL1, and a second emission control line ECL2. The first gate line GWL may transmit a first gate signal GW. The second gate line GRL may transmit a second gate signal GR. The third gate line GCL may transmit a third gate signal GC. The data line DL may transmit the data voltage VDATA. The first voltage line VL1 may transmit a first power voltage ELVDD having a relatively high voltage level. The second voltage line VL2 may transmit a second power voltage ELVSS having a relatively low voltage level. The third voltage line VL3 may transmit a reference voltage VREF. The reference voltage VREF may have a voltage level lower than a voltage level of the first power voltage ELVDD. The fourth voltage line VL4 may transmit an initialization voltage VCINT.

The first transistor T1 may include a gate terminal, a first terminal, and a second terminal. In some example embodiments, the first terminal of the first transistor T1 may be a source, and the second terminal of the first transistor T1 may be a drain. The gate terminal of the first transistor T1 may be connected to a first node N1. The first terminal of the first transistor T1 may be connected to a second node N2. The second terminal of the first transistor T1 may be connected to a third node N3. The second terminal of the first transistor T1 may be connected to the light-emitting element LD through the fifth transistor T5. The first transistor T1 may control a driving current ID supplied to the light-emitting element LD.

In some example embodiments, the first transistor T1 may further include a lower gate terminal. The lower gate terminal of the first transistor T1 may be connected to the second node N2. That is, the lower gate terminal of the first transistor T1 may be connected to the first terminal of the first transistor T1.

The second transistor T2 may include a gate terminal, a first terminal, and a second terminal. In some example embodiments, the first terminal of the second transistor T2 may be a source, and the second terminal of the second transistor T2 may be a drain. However, the present disclosure is not necessarily limited thereto, and the first terminal of the second transistor T2 may be a drain and the second terminal of the second transistor T2 may be a source. The gate terminal of the second transistor T2 may receive the first gate signal GW through the first gate line GWL. The first terminal of the second transistor T2 may receive the data voltage VDATA through the data line DL. The second terminal of the second transistor T2 may be connected to the first node N1.

The second transistor T2 may be turned on or turned off in response to the first gate signal GW. For example, when the second transistor T2 is an n-type transistor, the second transistor T2 may be turned off when the first gate signal GW has the low gate voltage and turned on when the first gate signal GW has the high gate voltage. While the second transistor T2 is turned on, the second transistor T2 may provide the data voltage VDATA to the first node N1. Accordingly, the second transistor T2 may drive the first transistor T1.

The third transistor T3 may include a gate terminal, a first terminal, and a second terminal. In some example embodiments, the first terminal of the third transistor T3 may be a source, and the second terminal of the third transistor T3 may be a drain. However, the present disclosure is not necessarily limited thereto, and the first terminal of the third transistor T3 may be a drain and the second terminal of the third transistor T3 may be a source. The gate terminal of the third transistor T3 may receive the second gate signal GR through the second gate line GRL. The first terminal of the third transistor T3 may be connected to the first node N1. The second terminal of the third transistor T3 may receive the reference voltage VREF through the third voltage line VL3.

The third transistor T3 may be turned on or turned off in response to the second gate signal GR. For example, when the third transistor T3 is an n-type transistor, the third transistor T3 may be turned off when the second gate signal GR has the low gate voltage and turned on when the second gate signal GR has the high gate voltage. While the third transistor T3 is turned on, the third transistor T3 may provide the reference voltage VREF to the first node N1.

The fourth transistor T4 may include a gate terminal, a first terminal, and a second terminal. In some example embodiments, the first terminal of the fourth transistor T4 may be a source, and the second terminal of the fourth transistor T4 may be a drain. However, the present disclosure is not necessarily limited thereto, and the first terminal of the fourth transistor T4 may be a drain and the second terminal of the fourth transistor T4 may be a source. The gate terminal of the fourth transistor T4 may receive the third gate signal GC through the third gate line GCL. The first terminal of the fourth transistor T4 may receive the initialization voltage VCINT through the fourth voltage line VL4. The second terminal of the fourth transistor T4 may be connected to a fourth node N4.

The fourth transistor T4 may be turned on or turned off in response to the third gate signal GC. For example, when the fourth transistor T4 is a p-type transistor, the fourth transistor T4 may be turned off when the third gate signal GC has the high gate voltage and turned on when the third gate signal GC has the low gate voltage. In addition, when the fourth transistor T4 is an n-type transistor, the fourth transistor T4 may be turned off when the third gate signal GC has the low gate voltage and turned on when the third gate signal GC has the high gate voltage. While the fourth transistor T4 is turned on, the fourth transistor T4 may provide the initialization voltage VCINT to the fourth node N4. That is, the fourth transistor T4 may provide the initialization voltage VCINT to a cathode of the light-emitting element LD in response to the third gate signal GC to initialize a voltage of the cathode.

The fifth transistor T5 may include a gate terminal, a first terminal, and a second terminal. In some example embodiments, the first terminal of the fifth transistor T5 may be a source, and the second terminal of the fifth transistor T5 may be a drain. However, the present disclosure is not necessarily limited thereto, and the first terminal of the fifth transistor T5 may be a drain and the second terminal of the fifth transistor T5 may be a source. The gate terminal of the fifth transistor T5 may receive the first emission control signal EM1 through the first emission control line ECL1. The first terminal of the fifth transistor T5 may be connected to the fourth node N4. That is, the first terminal of the fifth transistor T5 may be connected to the light-emitting element LD. The second terminal of the fifth transistor T5 may be connected to the third node N3. That is, the second terminal of the fifth transistor T5 may be connected to the second terminal of the first transistor T1.

The fifth transistor T5 may be turned on or turned off in response to the first emission control signal EM1. For example, when the fifth transistor T5 is a p-type transistor, the fifth transistor T5 may be turned off when the first emission control signal EM1 has the high gate voltage and turned on when the first emission control signal EM1 has the low gate voltage. In addition, when the fifth transistor T5 is an n-type transistor, the fifth transistor T5 may be turned off when the first emission control signal EM1 has the low gate voltage and turned on when the first emission control signal EM1 has the high gate voltage. While the fifth transistor T5 is turned on, the fifth transistor T5 may electrically connect the first transistor T1 and the light-emitting element LD. That is, the fifth transistor T5 may electrically connect the second terminal of the first transistor T1 and the cathode of the light-emitting element LD in response to the first emission control signal EM1.

The sixth transistor T6 may include a gate terminal, a first terminal, and a second terminal. In some example embodiments, the first terminal of the sixth transistor T6 may be a source, and the second terminal of the sixth transistor T6 may be a drain. However, the present disclosure is not necessarily limited thereto, and the first terminal of the sixth transistor T6 may be a drain and the second terminal of the sixth transistor T6 may be a source. The gate terminal of the sixth transistor T6 may receive the second emission control signal EM2 through the second emission control line ECL2. The first terminal of the sixth transistor T6 may receive the second power voltage ELVSS through the second voltage line VL2. The second terminal of the sixth transistor T6 may be connected to the second node N2.

The sixth transistor T6 may be turned on or turned off in response to the second emission control signal EM2. For example, when the sixth transistor T6 is an n-type transistor, the sixth transistor T6 may be turned off when the second emission control signal EM2 has the low gate voltage and turned on when the second emission control signal EM2 has the high gate voltage. While the sixth transistor T6 is turned on, the sixth transistor T6 may provide the second power voltage ELVSS to the second node N2.

Although the fifth transistor T5 and the sixth transistor T6 are illustrated in FIG. 3A as being independently driven by different emission control signals, the present disclosure is not necessarily limited thereto. For example, the fifth transistor T5 and the sixth transistor T6 may be turned on or off simultaneously (or contemporaneously) in response to a substantially single emission control signal. In this case, both the fifth transistor T5 and the sixth transistor T6 may be n-type transistors.

The first capacitor C1 may include a first terminal and a second terminal. The first terminal of the first capacitor C1 may be connected to the first node N1. The second terminal of the first capacitor C1 may be connected to the second node N2. The first capacitor C1 may be charged and discharged according to the data voltage VDATA transmitted to the first node N1.

The second capacitor C2 may include a first terminal and a second terminal. The first terminal of the second capacitor C2 may be connected to the second node N2. The second terminal of the second capacitor C2 may be connected to the second voltage line VL2. For example, the second capacitor C2 may be connected in series with the first capacitor C1. The data voltage VDATA may be transmitted to the first node N1, and the data voltage VDATA may be voltage-divided and transmitted to the second node N2 due to the series connection of the first capacitor C1 and the second capacitor C2. Since the first transistor T1 controls the driving current ID based on a voltage of the first node N1 and a voltage of the second node N2, a data range may be expanded.

The light-emitting element LD may include an anode and the cathode. The anode of the light-emitting element LD may be connected to the first voltage line VL1. The cathode of the light-emitting element LD may be connected to the fourth node N4. That is, the cathode of the light-emitting element LD may be connected to the second terminal of the first transistor T1 through the fifth transistor T5.

Although not illustrated in FIG. 3A, the pixel driving circuit PC may further include an emission capacitor including a first terminal and a second terminal. The first terminal of the emission capacitor may receive the first power voltage ELVDD. The second terminal of the emission capacitor may be connected to the fourth node N4.

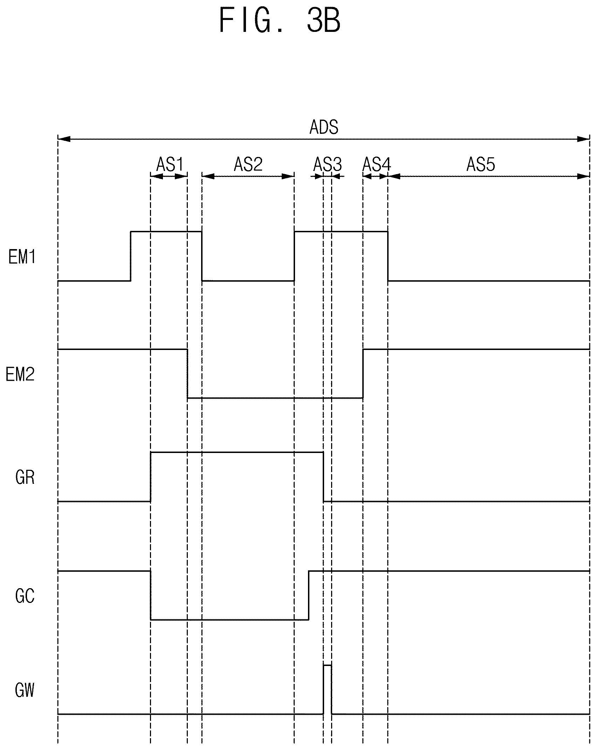

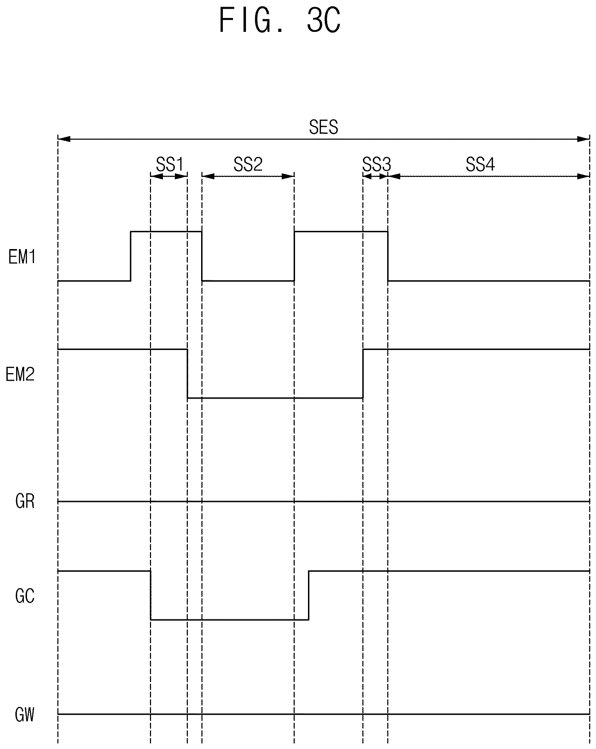

FIG. 3B is a timing diagram illustrating an example of the display device of FIG. 1 performing an address scan operation on the pixel of FIG. 3A. FIG. 3C is a timing diagram illustrating an example of the display device of FIG. 1 performing a self-scan operation on the pixel of FIG. 3A.

Referring to FIGS. 1, 3A, 3B, and 3C, the driving controller CON may perform an address scan operation ADS and a self-scan operation SES.

The driving controller CON may vary a driving frequency of the display panel DP (or a length of a driving frame) by adjusting a length of the self-scan operation SES. For example, at the maximum (or highest) driving frequency of the display panel DP (e.g., 240 Hz), one frame of the address scan operation ADS may be repeated successively. In this case, the driving controller CON may perform one frame of the address scan operation ADS as one driving frame. For example, when the driving frequency of the display panel DP is 120 Hz, one frame of the address scan operation ADS and one frame of the self-scan operation SES may be repeated. In this case, the driving controller CON may perform one frame of the address scan operation ADS and one frame of the self-scan operation SES as one driving frame. For example, when the driving frequency of the display panel DP is 60 Hz, 1 frame of the address scan operation ADS and 3 frames of the self-scan operation SES may be repeated. In this case, the driving controller CON may perform 1 frame of the address scan operation ADS and 3 frames of the self-scan operation SES as one driving frame. However, the present disclosure is not necessarily limited thereto.

As illustrated in FIG. 3B, the address scan operation ADS may include a first section AS1, a second section AS2, a third section AS3, a fourth section AS4, and a fifth section AS5.

In the first section AS1 of the address scan operation ADS, the first emission control signal EM1, the second emission control signal EM2, and the second gate signal GR may have the high gate voltage, and the first gate signal GW and the third gate signal GC may have the low gate voltage. In this case, the third transistor T3, the fourth transistor T4, and the sixth transistor T6 may be turned on, and the second transistor T2 and the fifth transistor T5 may be turned off. Accordingly, the reference voltage VREF may be applied to the gate terminal of the first transistor T1 so that a voltage of the gate terminal of the first transistor T1 may be initialized. In addition, the second power voltage ELVSS may be applied to the first terminal of the first transistor T1. In addition, the initialization voltage VCINT may be applied to the cathode of the light-emitting element LD so that a voltage of the cathode may be initialized. For example, the first section AS1 of the address scan operation ADS may be referred to as a gate initialization and cathode initialization operation.

In the second section AS2 of the address scan operation ADS, the first emission control signal EM1, the second emission control signal EM2, the first gate signal GW, and the third gate signal GC may have the low gate voltage, and the second gate signal GR may have the high gate voltage. In this case, the third transistor T3, the fourth transistor T4, and the fifth transistor T5 may be turned on, and the second transistor T2 and the sixth transistor T6 may be turned off. Accordingly, the reference voltage VREF may be applied to the gate terminal of the first transistor T1, and the initialization voltage VCINT may be applied to the second terminal of the first transistor T1 so that a threshold voltage of the first transistor T1 may be compensated. In addition, the initialization voltage VCINT may be applied to the cathode of the light-emitting element LD so that a voltage of the cathode may be initialized. For example, the second section AS2 of the address scan operation ADS may be referred to as a threshold voltage compensation and cathode initialization operation.

In the third section AS3 of the address scan operation ADS, the first emission control signal EM1, the first gate signal GW, and the third gate signal GC may have the high gate voltage, and the second emission control signal EM2 and the second gate signal GR may have the low gate voltage. In this case, the second transistor T2 may be turned on, and the third to sixth transistors T3, T4, T5, and T6 may be turned off. Accordingly, the data voltage VDATA may be applied to the gate terminal of the first transistor T1. For example, the third section AS3 of the address scan operation ADS may be referred to as a data writing operation.

In the fourth section AS4 of the address scan operation ADS, the first emission control signal EM1, the second emission control signal EM2, and the third gate signal GC may have the high gate voltage, and the first gate signal GW and the second gate signal GR may have the low gate voltage. In this case, the sixth transistor T6 may be turned on, and the second to fifth transistors T2, T3, T4, and T5 may be turned off. Accordingly, the second power voltage ELVSS may be applied to the first terminal of the first transistor T1. For example, the fourth section AS4 of the address scan operation ADS may be referred to as a source initialization operation.

In the fifth section AS5 of the address scan operation ADS, the first emission control signal EM1, the first gate signal GW, and the second gate signal GR may have the low gate voltage, and the second emission control signal EM2 and the third gate signal GC may have the high gate voltage. In this case, the fifth transistor T5 and the sixth transistor T6 may be turned on, and the second to fourth transistors T2, T3, and T4 may be turned off. Accordingly, the first transistor T1 may generate the driving current ID based on the gate terminal, and the light-emitting element LD may emit due to the driving current ID. For example, the fifth section AS5 of the address scan operation ADS may be referred to as an emission operation.

As illustrated in FIG. 3C, the self-scan operation SES may include a first section SS1, a second section SS2, a third section SS3, and a fourth section SS4.

In the first section SS1 of the self-scan operation SES, the first emission control signal EM1, the second emission control signal EM2 may have the high gate voltage, and the first gate signal GW, the second gate signal GR, and the third gate signal GC may have the low gate voltage. In this case, the fourth transistor T4 and the sixth transistor T6 may be turned on, and the second transistor T2, the third transistor T3, and the fifth transistor T5 may be turned off. Accordingly, the second power voltage ELVSS may be applied to the first terminal of the first transistor T1. In addition, the initialization voltage VCINT may be applied to the cathode of the light-emitting element LD so that a voltage of the cathode may be initialized. Unlike the first section AS1 of the address scan operation ADS, the first section SS1 of the self-scan operation SES may not include an operation of initializing a voltage of the gate terminal of the first transistor T1. For example, the first section SS1 of the self-scan operation SES may be referred to as a cathode initialization operation.

In the second section SS2 of the self-scan operation SES, the first emission control signal EM1, the second emission control signal EM2, the first gate signal GW, the second gate signal GR, and the third gate signal GC may all have the low gate voltage. In this case, the fourth transistor T4 and the fifth transistor T5 may be turned on, and the second transistor T2, the third transistor T3, and the sixth transistor T6 may be turned off. Accordingly, the initialization voltage VCINT may be applied to the second terminal of the first transistor T1 so that a threshold voltage of the first transistor T1 may be compensated. In addition, the initialization voltage VCINT may be applied to the cathode of the light-emitting element LD so that a voltage of the cathode may be initialized. For example, the second section SS2 of the self-scan operation SES may be referred to as a threshold voltage compensation and cathode initialization operation.

Unlike the address scan operation ADS, the self-scan operation SES may not include a data writing operation of applying the data voltage VDATA to the gate terminal of the first transistor T1.

In the third section SS3 of the self-scan operation SES, the first emission control signal EM1, the second emission control signal EM2, and the third gate signal GC may have the high gate voltage, and the first gate signal GW and the second gate signal GR may have the low gate voltage. In this case, the sixth transistor T6 may be turned on, and the second to fifth transistors T2, T3, T4, and T5 may be turned off. Accordingly, the second power voltage ELVSS may be applied to the first terminal of the first transistor T1. For example, the third section SS3 of the self-scan operation SES may be referred to as a source initialization operation.

In the fourth section SS4 of the self-scan operation SES, the first emission control signal EM1, the first gate signal GW, and the second gate signal GR may have the low gate voltage, and the second emission control signal EM2 and the third gate signal GC may have the high gate voltage. In this case, the fifth transistor T5 and the sixth transistor T6 may be turned on, and the second to fourth transistors T2, T3, and T4 may be turned off. Accordingly, the first transistor T1 may generate the driving current ID based on the gate terminal, and the light-emitting element LD may emit due to the driving current ID. For example, the fourth section SS4 of the self-scan operation SES may be referred to as an emission operation.

In summary, the address scan operation ADS may perform the gate initialization operation, the cathode initialization operation, the threshold voltage compensation operation, the data writing operation, the source initialization operation, and the emission operation. The self-scan operation SES may perform the cathode initialization operation, the threshold voltage compensation operation, the source initialization operation, and the emission operation. That is, the self-scan operation SES may perform the emission operation without the gate initialization operation and the data writing operation. In the self-scan operation SES, the first gate signal GW and the second gate signal GR may maintain the low gate voltage.

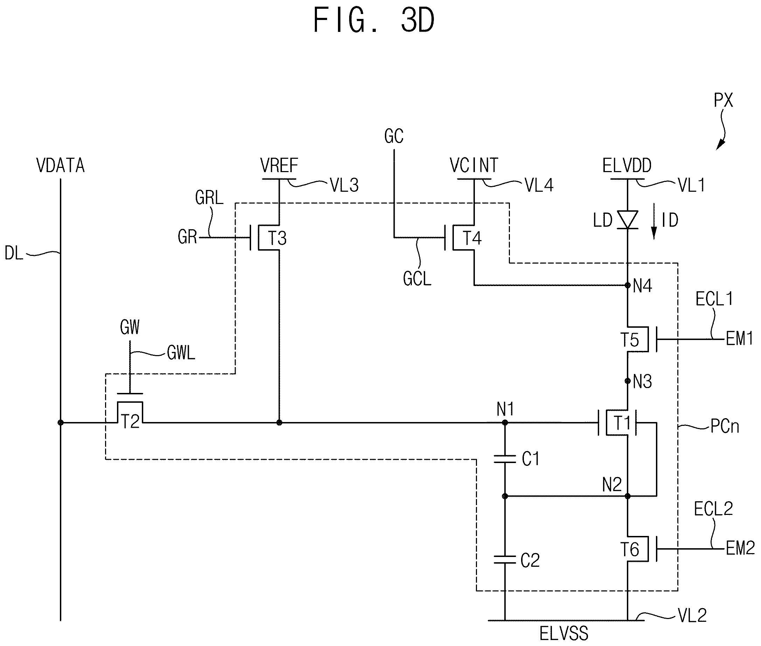

FIG. 3D is a circuit diagram illustrating another example of a circuit structure of a pixel included in the display device of FIG. 1. For example, FIG. 3D may be a circuit diagram of any one of the first to third sub-pixels included in the pixel PX.

A pixel driving circuit PCn of FIG. 3D may be substantially the same as the pixel driving circuit PC described above with reference to FIG. 3A, except that the fourth transistor T4 and the fifth transistor T5 are n-type transistors. Accordingly, redundant descriptions of some components are omitted or summarized.

Referring to FIG. 3D, the pixel PX may include a light-emitting element LD and the pixel driving circuit PCn connected to the light-emitting element LD. In some example embodiments, the pixel driving circuit PCn may include first to six transistors T1, T2, T3, T4, T5, and T6, a first capacitor C1, and a second capacitor C2. In some example embodiments, the first to sixth transistors T1, T2, T3, T4, T5, and T6 may all be n-type transistors.

The fourth transistor T4 may include a gate terminal, a first terminal, and a second terminal. In some example embodiments, the first terminal of the fourth transistor T4 may be a source, and the second terminal of the fourth transistor T4 may be a drain. However, the present disclosure is not necessarily limited thereto, and the first terminal of the fourth transistor T4 may be a drain and the second terminal of the fourth transistor T4 may be a source. The gate terminal of the fourth transistor T4 may receive the third gate signal GC through the third gate line GCL. The first terminal of the fourth transistor T4 may be connected to the fourth node N4. The second terminal of the fourth transistor T4 may receive the initialization voltage VCINT through the fourth voltage line VL4.

The fourth transistor T4 may be turned on or turned off in response to the third gate signal GC. For example, when the fourth transistor T4 is an n-type transistor, the fourth transistor T4 may be turned off when the third gate signal GC has the low gate voltage and turned on when the third gate signal GC has the high gate voltage. While the fourth transistor T4 is turned on, the fourth transistor T4 may provide the initialization voltage VCINT to the fourth node N4. That is, the fourth transistor T4 may provide the initialization voltage VCINT to a cathode of the light-emitting element LD in response to the third gate signal GC to initialize a voltage of the cathode.

The fifth transistor T5 may include a gate terminal, a first terminal, and a second terminal. In some example embodiments, the first terminal of the fifth transistor T5 may be a source, and the second terminal of the fifth transistor T5 may be a drain. However, the present disclosure is not necessarily limited thereto, and the first terminal of the fifth transistor T5 may be a drain and the second terminal of the fifth transistor T5 may be a source. The gate terminal of the fifth transistor T5 may receive the first emission control signal EM1 through the first emission control line ECL1. The first terminal of the fifth transistor T5 may be connected to the third node N3. That is, the first terminal of the fifth transistor T5 may be connected to the second terminal of the first transistor T1. The second terminal of the fifth transistor T5 may be connected to the fourth node N4. That is, the second terminal of the fifth transistor T5 may be connected to the light-emitting element LD.

The fifth transistor T5 may be turned on or turned off in response to the first emission control signal EM1. For example, when the fifth transistor T5 is an n-type transistor, the fifth transistor T5 may be turned off when the first emission control signal EM1 has the low gate voltage and turned on when the first emission control signal EM1 has the high gate voltage. While the fifth transistor T5 is turned on, the fifth transistor T5 may electrically connect the first transistor T1 and the light-emitting element LD. That is, the fifth transistor T5 may electrically connect the second terminal of the first transistor T1 and the cathode of the light-emitting element LD in response to the first emission control signal EM1.

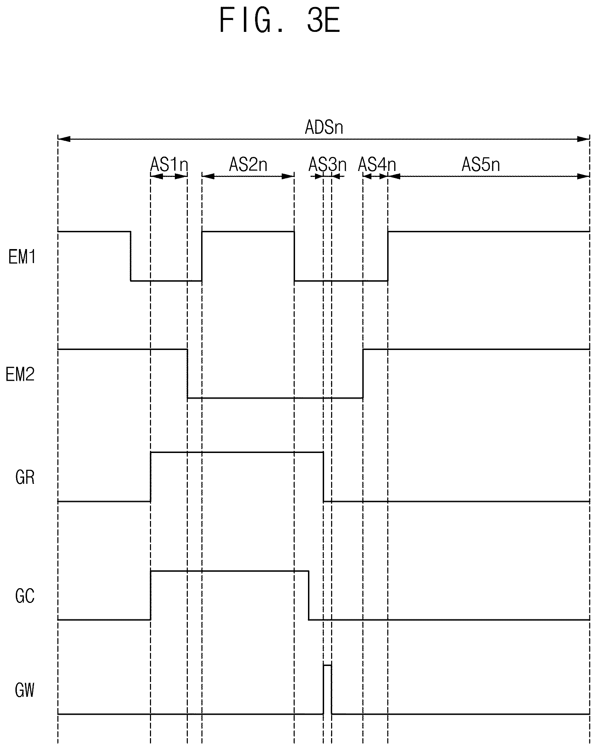

FIG. 3E is a timing diagram illustrating an example of the display device of FIG. 1 performing an address scan operation on the pixel of FIG. 3D.

An address scan section ADSn of FIG. 3E may be substantially the same as the address scan section ADS described above with reference to FIG. 3B, except for the first emission control signal EM1 and the third gate signal GC.

Referring to FIGS. 1, 3D, and 3E, the driving controller CON may perform the address scan operation ADSn and a self-scan operation. The driving controller CON may vary a driving frequency of the display panel DP by adjusting a length of the self-scan operation.

As illustrated in FIG. 3E, the address scan operation ADSn may include a first section AS1n, a second section AS2n, a third section AS3n, a fourth section AS4n, and a fifth section AS5n.

In the first section AS1n of the address scan operation ADSn, the second emission control signal EM2, the second gate signal GR, and the third gate signal GC may have the high gate voltage, and the first emission control signal EM1 and the first gate signal GW may have the low gate voltage. In this case, the third transistor T3, the fourth transistor T4, and the sixth transistor T6 may be turned on, and the second transistor T2 and the fifth transistor T5 may be turned off. Accordingly, the reference voltage VREF may be applied to the gate terminal of the first transistor T1 so that a voltage of the gate terminal of the first transistor T1 may be initialized. In addition, the second power voltage ELVSS may be applied to the first terminal of the first transistor T1. In addition, the initialization voltage VCINT may be applied to the cathode of the light-emitting element LD so that a voltage of the cathode may be initialized. For example, the first section AS1n of the address scan operation ADSn may be referred to as a gate initialization and cathode initialization operation.

In the second section AS2n of the address scan operation ADSn, the first emission control signal EM1, the second gate signal GR, and the third gate signal GC may have the high gate voltage, and the second emission control signal EM2 and the first gate signal GW may have the low gate voltage. In this case, the third transistor T3, the fourth transistor T4, and the fifth transistor T5 may be turned on, and the second transistor T2 and the sixth transistor T6 may be turned off. Accordingly, the reference voltage VREF may be applied to the gate terminal of the first transistor T1, and the initialization voltage VCINT may be applied to the second terminal of the first transistor T1 so that a threshold voltage of the first transistor T1 may be compensated. In addition, the initialization voltage VCINT may be applied to the cathode of the light-emitting element LD so that a voltage of the cathode may be initialized. For example, the second section AS2n of the address scan operation ADSn may be referred to as a threshold voltage compensation and cathode initialization operation.

In the third section AS3n of the address scan operation ADSn, the first gate signal GW may have the high gate voltage, and the first emission control signal EM1, the second emission control signal EM2, the second gate signal GR, and the third gate signal GC may have the low gate voltage. In this case, the second transistor T2 may be turned on, and the third to sixth transistors T3, T4, T5, and T6 may be turned off. Accordingly, the data voltage VDATA may be applied to the gate terminal of the first transistor T1. For example, the third section AS3n of the address scan operation ADSn may be referred to as a data writing operation.

In the fourth section AS4n of the address scan operation ADSn, the second emission control signal EM2 may have the high gate voltage, and the first emission control signal EM1, the first gate signal GW, the second gate signal GR, and the third gate signal GC may have the low gate voltage. In this case, the sixth transistor T6 may be turned on, and the second to fifth transistors T2, T3, T4, and T5 may be turned off. Accordingly, the second power voltage ELVSS may be applied to the first terminal of the first transistor T1. For example, the fourth section AS4n of the address scan operation ADSn may be referred to as a source initialization operation.

In the fifth section AS5n of the address scan operation ADSn, the first emission control signal EM1 and the second emission control signal EM2 may have the high gate voltage, and the first gate signal GW, the second gate signal GR, and the third gate signal GC may have the low gate voltage. In this case, the fifth transistor T5 and the sixth transistor T6 may be turned on, and the second to fourth transistors T2, T3, and T4 may be turned off. Accordingly, the first transistor T1 may generate the driving current ID based on the gate terminal, and the light-emitting element LD may emit due to the driving current ID. For example, the fifth section AS5n of the address scan operation ADSn may be referred to as an emission operation.

A difference between the address scan operation ADSn and the self-scan operation performed on the pixel PX of FIG. 3D may be substantially the same as a difference between the address scan operation ADS and the self-scan operation SES performed on the pixel PX of FIG. 3A. That is, the address scan operation ADSn may perform the gate initialization operation, the cathode initialization operation, the threshold voltage compensation operation, the data writing operation, the source initialization operation, and the emission operation, and the self-scan operation may perform the cathode initialization operation, the threshold voltage compensation operation, the source initialization operation, and the emission operation. In other words, the self-scan operation may perform the emission operation without the gate initialization operation and the data writing operation. In the self-scan operation, the first gate signal GW and the second gate signal GR may maintain the low gate voltage.

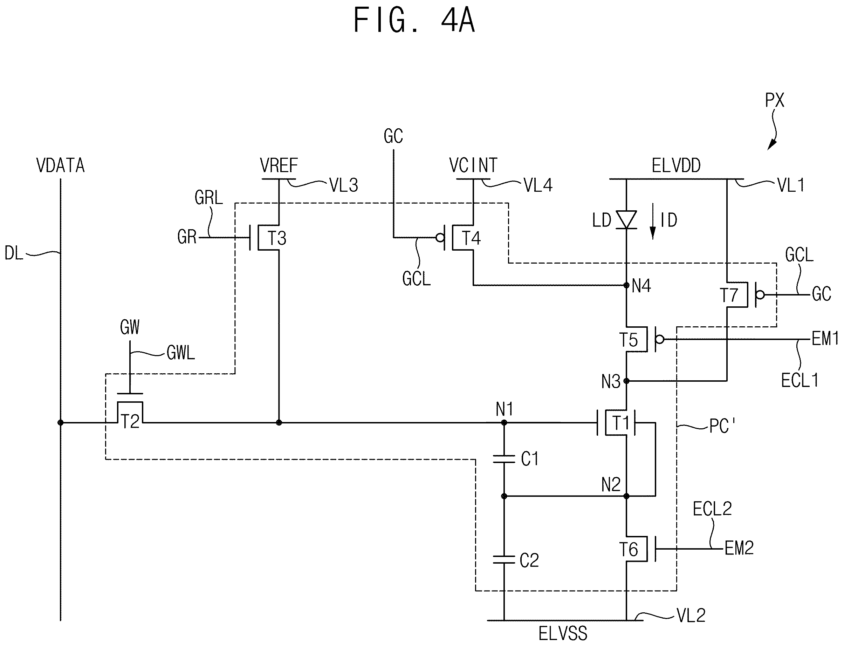

FIG. 4A is a circuit diagram illustrating still another example of a circuit structure of a pixel included in the display device of FIG. 1. For example, FIG. 4A may be a circuit diagram of any one of the first to third sub-pixels included in the pixel PX.

Compared to the example of the circuit structure of the pixel PX described above with reference to FIG. 3A, in some example embodiments of the circuit structure of the pixel PX described with reference to FIG. 4A, the pixel driving circuit PC' may further include a seventh transistor T7. Accordingly, redundant descriptions of some components are omitted or summarized.

Referring to FIG. 4A, the pixel PX may include a light-emitting element LD and the pixel driving circuit PC' connected to the light-emitting element LD. In some example embodiments, the pixel driving circuit PC' may include first to seventh transistors T1, T2, T3, T4, T5, T6, and T7, a first capacitor C1, and a second capacitor C2.

In FIG. 4A, the fourth transistor T4, the fifth transistor T5, and the seventh transistor T7 are illustrated as p-type transistors, and the first to third transistors T1, T2, and T3 and the sixth transistor T6 are illustrated as n-type transistors. However, the present disclosure is not necessarily limited thereto, and the first to seventh transistors T1, T2, T3, T4, T5, T6, and T7 may all be n-type transistors.

The first to sixth transistors T1, T2, T3, T4, T5, and T6, the first capacitor C1, and the second capacitor C2 of FIG. 4A may be substantially the same as the first to sixth transistors T1, T2, T3, T4, T5, and T6, the first capacitor C1, and the second capacitor C2 described above with reference to FIG. 3A. Accordingly, the descriptions of the first to sixth transistors T1, T2, T3, T4, T5, and T6, the first capacitor C1, and the second capacitor C2 described above with reference to FIG. 3A may be equally (or similarly) applied. Accordingly, redundant descriptions are omitted.

The seventh transistor T7 may include a gate terminal, a first terminal, and a second terminal. In some example embodiments, the first terminal of the seventh transistor T7 may be a source, and the second terminal of the seventh transistor T7 may be a drain. However, the present disclosure is not necessarily limited thereto, and the first terminal of the seventh transistor T7 may be a drain and the second terminal of the seventh transistor T7 may be a source. The gate terminal of the seventh transistor T7 may receive the third gate signal GC through the third gate line GCL. The first terminal of the seventh transistor T7 may receive the first power voltage ELVDD through the first voltage line VL1. The second terminal of the seventh transistor T7 may be connected to the third node N3.

The seventh transistor T7 may be turned on or turned off in response to the third gate signal GC. For example, when the seventh transistor T7 is a p-type transistor, the seventh transistor T7 may be turned off when the third gate signal GC has the high gate voltage and turned on when the third gate signal GC has the low gate voltage. In addition, when the seventh transistor T7 is an n-type transistor, the seventh transistor T7 may be turned off when the third gate signal GC has the low gate voltage and turned on when the third gate signal GC has the high gate voltage. While the seventh transistor T7 is turned on, the seventh transistor T7 may provide the first power voltage ELVDD to the third node N3.

Although a gate line connected to the fourth transistor T4 and a gate line connected to the seventh transistor T7 are illustrated in FIG. 4A as a single gate line (e.g., the third gate line GCL), the present disclosure is not necessarily limited thereto. For example, a gate line connected to the fourth transistor T4 and a gate line connected to the seventh transistor T7 may be gate lines that are distinct from each other.

In addition, although the fourth transistor T4 and the seventh transistor T7 are illustrated in FIG. 4A as being simultaneously (or contemporaneously) driven by the third gate signal GC, the present disclosure is not necessarily limited thereto. For example, the fourth transistor T4 and the seventh transistor T7 may be independently driven by different signals.

The light-emitting element LD of FIG. 4A may be substantially the same as the light-emitting element LD described above with reference to FIG. 3A. Accordingly, the descriptions of the light-emitting element LD described above with reference to FIG. 3A may be equally (or similarly) applied. Accordingly, redundant descriptions are omitted.

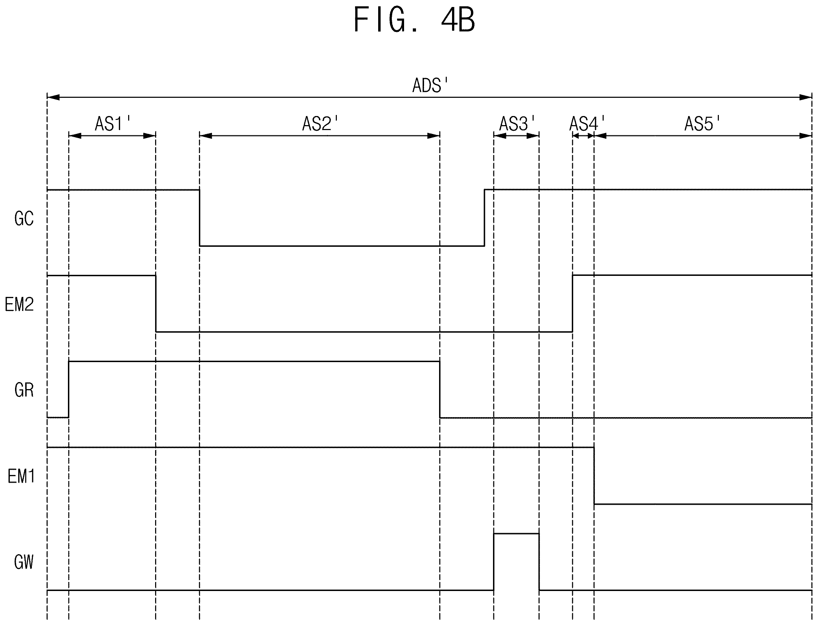

FIG. 4B is a timing diagram illustrating an example of the display device of FIG. 1 performing an address scan operation on the pixel of FIG. 4A.

Referring to FIGS. 1, 4A, and 4B, the driving controller CON may perform an address scan operation ADS' and a self-scan operation. The driving controller CON may vary a driving frequency of the display panel DP by adjusting a length of the self-scan operation.

As illustrated in FIG. 4B, the address scan operation ADS' may include a first section AS1', a second section AS2', a third section AS3', a fourth section AS4', and a fifth section AS5'.

In the first section AS1' of the address scan operation ADS', the first emission control signal EM1, the second emission control signal EM2, the second gate signal GR, and the third gate signal GC may have the high gate voltage, and the first gate signal GW may have the low gate voltage. In this case, the third transistor T3 and the sixth transistor T6 may be turned on, and the second transistor T2, the fourth transistor T4, the fifth transistor T5, and the seventh transistor T7 may be turned off. Accordingly, the reference voltage VREF may be applied to the gate terminal of the first transistor T1 so that a voltage of the gate terminal of the first transistor T1 may be initialized. In addition, the second power voltage ELVSS may be applied to the first terminal of the first transistor T1. For example, the first section AS1' of the address scan operation ADS' may be referred to as a gate initialization operation.

In the second section AS2' of the address scan operation ADS', the first emission control signal EM1 and the second gate signal GR may have the high gate voltage, and the second emission control signal EM2, the first gate signal GW, and the third gate signal GC may have the low gate voltage. In this case, the third transistor T3, the fourth transistor T4, and the seventh transistor T7 may be turned on, and the second transistor T2, the fifth transistor T5, and the sixth transistor T6 may be turned off. Accordingly, the reference voltage VREF may be applied to the gate terminal of the first transistor T1, and the first power voltage ELVDD may be applied to the second terminal of the first transistor T1, so that a threshold voltage of the first transistor T1 may be compensated. In addition, the initialization voltage VCINT may be applied to the cathode of the light-emitting element LD so that a voltage of the cathode may be initialized. For example, the second section AS2' of the address scan operation ADS' may be referred to as a threshold voltage compensation and cathode initialization operation.

In the third section AS3' of the address scan operation ADS', the first emission control signal EM1, the first gate signal GW, and the third gate signal GC may have the high gate voltage, and the second emission control signal EM2 and the second gate signal GR may have the low gate voltage. In this case, the second transistor T2 may be turned on, and the third to seventh transistors T3, T4, T5, T6, and T7 may be turned off. Accordingly, the data voltage VDATA may be applied to the gate terminal of the first transistor T1. For example, the third section AS3' of the address scan operation ADS' may be referred to as a data writing operation.

In the fourth section AS4' of the address scan operation ADS', the first emission control signal EM1, the second emission control signal EM2, and the third gate signal GC may have the high gate voltage, and the first gate signal GW and the second gate signal GR may have the low gate voltage. In this case, the sixth transistor T6 may be turned on, and the second to fifth transistors T2, T3, T4, and T5, and the seventh transistor T7 may be turned off. Accordingly, the second power voltage ELVSS may be applied to the first terminal of the first transistor T1. For example, the fourth section AS4' of the address scan operation ADS' may be referred to as a source initialization operation.

In the fifth section AS5' of the address scan operation ADS', the first emission control signal EM1, the first gate signal GW, and the second gate signal GR may have the low gate voltage, and the second emission control signal EM2 and the third gate signal GC may have the high gate voltage. In this case, the fifth transistor T5 and the sixth transistor T6 may be turned on, and the second to fourth transistors T2, T3, and T4 and the seventh transistor T7 may be turned off. Accordingly, the first transistor T1 may generate the driving current ID based on the gate terminal, and the light-emitting element LD may emit due to the driving current ID. For example, the fifth section AS5' of the address scan operation ADS' may be referred to as an emission operation.

A difference between the address scan operation ADS' and the self-scan operation performed on the pixel PX of FIG. 4A may be substantially the same as a difference between the address scan operation ADS and the self-scan operation SES performed on the pixel PX of FIG. 3A. That is, the address scan operation ADS' may perform the gate initialization operation, the cathode initialization operation, the threshold voltage compensation operation, the data writing operation, the source initialization operation, and the emission operation, and the self-scan operation may perform the cathode initialization operation, the threshold voltage compensation operation, the source initialization operation, and the emission operation. In other words, the self-scan operation may perform the emission operation without the gate initialization operation and the data writing operation. In the self-scan operation, the first gate signal GW and the second gate signal GR may maintain the low gate voltage.

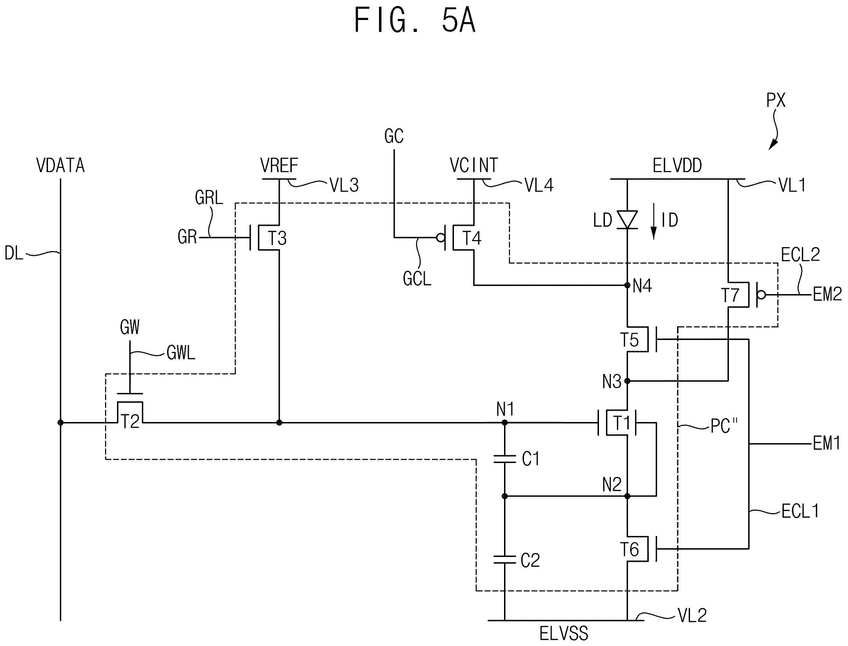

FIG. 5A is a circuit diagram illustrating still another example of a circuit structure of a pixel included in the display device of FIG. 1. For example, FIG. 5A may be a circuit diagram of any one of the first to third sub-pixels included in the pixel PX.

The pixel driving circuit part PC" of FIG. 5A may be substantially the same as the pixel driving circuit PC' described above with reference to FIG. 4A, except for signals applied to gate electrodes of fifth to seventh transistors T5, T6, and T7. Accordingly, redundant descriptions of some components are omitted or summarized.

Referring to FIG. 5A, the pixel PX may include a light-emitting element LD and the pixel driving circuit PC" connected to the light-emitting element LD. In some example embodiments, the pixel driving circuit PC" may include first to seventh transistors T1, T2, T3, T4, T5, T6, and T7, a first capacitor C1, and a second capacitor C2.

In FIG. 5A, the fourth transistor T4 and the seventh transistor T7 are illustrated as p-type transistors, and the first to third transistors T1, T2, and T3, the fifth transistor T5, and the sixth transistor T6 are illustrated as n-type transistors. However, the present disclosure is not necessarily limited thereto, and the first to seventh transistors T1, T2, T3, T4, T5, T6, and T7 may all be n-type transistors.

The fifth transistor T5 may include a gate terminal, a first terminal, and a second terminal. In some example embodiments, the first terminal of the fifth transistor T5 may be a source, and the second terminal of the fifth transistor T5 may be a drain. However, the present disclosure is not necessarily limited thereto, and the first terminal of the fifth transistor T5 may be a drain and the second terminal of the fifth transistor T5 may be a source. The gate terminal of the fifth transistor T5 may receive a first emission control signal EM1 through a first emission control line ECL1. The first terminal of the fifth transistor T5 may be connected to the third node N3. That is, the first terminal of the fifth transistor T5 may be connected to the second terminal of the first transistor T1. The second terminal of the fifth transistor T5 may be connected to the fourth node N4. That is, the second terminal of the fifth transistor T5 may be connected to the light-emitting element LD.

The fifth transistor T5 may be turned on or turned off in response to the first emission control signal EM1. For example, when the fifth transistor T5 is an n-type transistor, the fifth transistor T5 may be turned off when the first emission control signal EM1 has the low gate voltage and turned on when the first emission control signal EM1 has the high gate voltage. While the fifth transistor T5 is turned on, the fifth transistor T5 may electrically connect the first transistor T1 and the light-emitting element LD. That is, the fifth transistor T5 may electrically connect the second terminal of the first transistor T1 and the cathode of the light-emitting element LD in response to the first emission control signal EM1.

The sixth transistor T6 may include a gate terminal, a first terminal, and a second terminal. In some example embodiments, the first terminal of the sixth transistor T6 may be a source, and the second terminal of the sixth transistor T6 may be a drain. However, the present disclosure is not necessarily limited thereto, and the first terminal of the sixth transistor T6 may be a drain and the second terminal of the sixth transistor T6 may be a source. The gate terminal of the sixth transistor T6 may receive the first emission control signal EM1 through the first emission control line ECL1. The first terminal of the sixth transistor T6 may receive the second power voltage ELVSS through the second voltage line VL2. The second terminal of the sixth transistor T6 may be connected to the second node N2.

The sixth transistor T6 may be turned on or turned off in response to the first emission control signal EM1. For example, when the sixth transistor T6 is an n-type transistor, the sixth transistor T6 may be turned off when the first emission control signal EM1 has the low gate voltage and turned on when the first emission control signal EM1 has the high gate voltage. While the sixth transistor T6 is turned on, the sixth transistor T6 may provide the second power voltage ELVSS to the second node N2.

In FIG. 5A, the fifth transistor T5 and the sixth transistor T6 may be turned on or off simultaneously (or contemporaneously) in response to a substantially single emission control signal (e.g., the first emission control signal EM1). However, the present disclosure is not necessarily limited thereto.

The seventh transistor T7 may include a gate terminal, a first terminal, and a second terminal. In some example embodiments, the first terminal of the seventh transistor T7 may be a source, and the second terminal of the seventh transistor T7 may be a drain. However, the present disclosure is not necessarily limited thereto, and the first terminal of the seventh transistor T7 may be a drain and the second terminal of the seventh transistor T7 may be a source. The gate terminal of the seventh transistor T7 may receive a second emission control signal EM2 through a second emission control line ECL2. The first terminal of the seventh transistor T7 may receive the first power voltage ELVDD through the first voltage line VL1. The second terminal of the seventh transistor T7 may be connected to the third node N3.

The seventh transistor T7 may be turned on or turned off in response to the second emission control signal EM2. For example, when the seventh transistor T7 is a p-type transistor, the seventh transistor T7 may be turned off when the second emission control signal EM2 has the high gate voltage and turned on when the second emission control signal EM2 has the low gate voltage. While the seventh transistor T7 is turned on, the seventh transistor T7 may provide the first power voltage ELVDD to the third node N3.

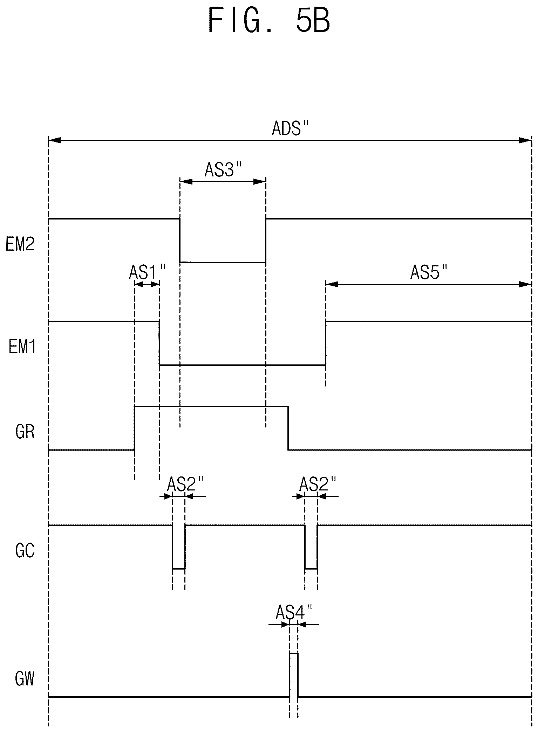

FIG. 5B is a timing diagram illustrating an example of the display device of FIG. 1 performing an address scan operation on the pixel of FIG. 5A.

Referring to FIGS. 1, 5A, and 5B, the driving controller CON may perform an address scan operation ADS'' and a self-scan operation. The driving controller CON may vary a driving frequency of the display panel DP by adjusting a length of the self-scan operation.

As illustrated in FIG. 5B, the address scan operation ADS" may include a first section AS1", a second section AS2", a third section AS3", a fourth section AS4", and a fifth section AS5".

In the first section AS1" of the address scan operation ADS", the first emission control signal EM1, the second emission control signal EM2, the second gate signal GR, and the third gate signal GC may have the high gate voltage, and the first gate signal GW may have the low gate voltage. In this case, the third transistor T3, the fifth transistor T5, and the sixth transistor T6 may be turned on, and the second transistor T2, the fourth transistor T4, and the seventh transistor T7 may be turned off. Accordingly, the reference voltage VREF may be applied to the gate terminal of the first transistor T1 so that a voltage of the gate terminal of the first transistor T1 may be initialized. The second power voltage ELVSS may be applied to the first terminal of the first transistor T1. For example, the first section AS1" of the address scan operation ADS" may be referred to as a gate initialization operation.

In the second segment AS2" of the address scan operation ADS", the first emission control signal EM1, the first gate signal GW, and the third gate signal GC may have the low gate voltage. The second gate signal GR and the second emission control signal EM2 may have the low gate voltage or the high gate voltage. In this case, the fourth transistor T4 may be turned on, and the second transistor T2, the fifth transistor T5, and the sixth transistor T6 may be turned off. The third transistor T3 and the seventh transistor T7 may be turned on, or may be turned off. Accordingly, the initialization voltage VCINT may be applied to the cathode of the light-emitting element LD so that a voltage of the cathode may be initialized. For example, the second section AS2" of the address scan operation ADS" may be referred to as a cathode initialization operation.

In the third section AS3" of the address scan operation ADS", the first emission control signal EM1, the second emission control signal EM2, and the first gate signal GW may have the low gate voltage, and the second gate signal GR may have the high gate voltage. The third gate signal GC may have the low gate voltage or the high gate voltage. In this case, the third transistor T3 and the seventh transistor T7 may be turned on, and the second transistor T2, the fifth transistor T5, and the sixth transistor T6 may be turned off. The fourth transistor T4 may be turned on or may be turned off. Accordingly, the reference voltage VREF may be applied to the gate terminal of the first transistor T1, and the first power voltage ELVDD may be applied to the second terminal of the first transistor T1, so that a threshold voltage of the first transistor T1 may be compensated. For example, the third section AS3" of the address scan operation ADS" may be referred to as a threshold voltage compensation operation.

In the fourth section AS4" of the address scan operation ADS", the second emission control signal EM2, the first gate signal GW, and the third gate signal GC may have the high gate voltage, and the first emission control signal EM1 and the second gate signal GR may have the low gate voltage. Accordingly, the second transistor T2 may be turned on, and the third to seventh transistors T3, T4, T5, T6, and T7 may be turned off. Accordingly, the data voltage VDATA may be applied to the gate terminal of the first transistor T1. For example, the fourth section AS4" of the address scan operation ADS" may be referred to as a data writing operation.

In the fifth section AS5" of the address scan operation ADS", the first emission control signal EM1, the second emission control signal EM2, and the third gate signal GC may have the high gate voltage, and the first gate signal GW and the second gate signal GR may have the low gate voltage. In this case, the fifth transistor T5 and the sixth transistor T6 may be turned on, and the second to fourth transistors T2, T3, and T4 and the seventh transistor T7 may be turned off. Accordingly, the first transistor T1 may generate the driving current ID based on the gate terminal, and the light-emitting element LD may emit due to the driving current ID. For example, the fifth section AS5" of the address scan operation ADS" may be referred to as an emission operation.

A difference between the address scan operation ADS" and the self-scan operation performed on the pixel PX of FIG. 5A may be substantially the same as a difference between the address scan operation ADS and the self-scan operation SES performed on the pixel PX of FIG. 3A. That is, the self-scan operation may serve the emission operation without the gate initialization operation and the data writing operation. In the self-scan operation, the first gate signal GW and the second gate signal GR may maintain the low gate voltage.

According to some example embodiments, as illustrated in FIGS. 3A, 3D, 4A, and 5A, the anode of the light-emitting element LD may receive the first power voltage ELVDD through the first voltage line VL1, and the cathode of the light-emitting element LD may be connected to the second terminal of the first transistor T1. That is, a potential of the cathode of the light-emitting element LD may be controlled by being electrically connected to the first transistor T1.

Since the first voltage line VL1 provides the first power voltage ELVDD (or a driving voltage) having a relatively high voltage level, and the second voltage line VL2 provides the second power voltage ELVSS (or a common voltage) having a relatively low voltage level, when the first transistor T1 is an n-type transistor, the second terminal of the first transistor T1 may be a drain. That is, according to some example embodiments, the cathode of the light-emitting element LD may be connected to the drain of the first transistor T1.

When the first transistor T1 is an n-type transistor, if the anode of the light-emitting element LD is connected to a source of the first transistor T1, a source voltage of the first transistor T1 may shift due to deterioration of the light-emitting element LD, causing a gate-source voltage (Vgs) of the first transistor T1 to change. As a result, the range of change in the driving current ID may increase, causing afterimage defects and reducing the lifespan of a display device.

According to some example embodiments, the anode of the light-emitting element LD may receive the first power voltage ELVDD, and the cathode of the light-emitting element LD may be connected to the drain of the first transistor T1. Accordingly, the gate-source voltage (Vgs) of the first transistor T1 may not change even when the light-emitting element LD deteriorates. Accordingly, the range of change in the driving current ID due to the deterioration of the light-emitting element LD may be reduced. Accordingly, the afterimage defects of the display device DD due to increased usage time may be reduced, and the lifetime of the display device DD may be improved (e.g., increased).

The circuit structures (e.g., the number or arrangement relationship of transistors, the number or arrangement relationship of capacitors, etc.) of the pixel illustrated in FIGS. 3A, 3D, 4A, and 5A are merely examples, and may be varied according to some example embodiments.

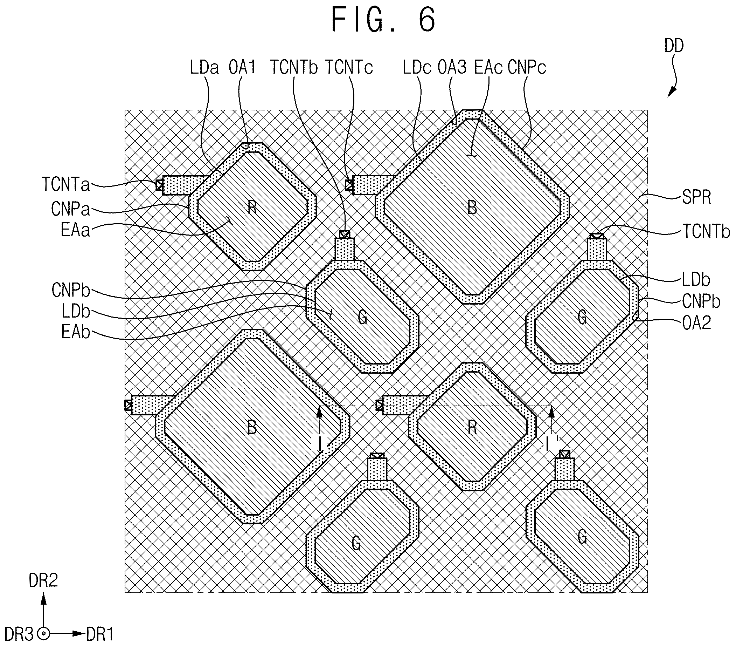

FIG. 6 is a plan view schematically illustrating a portion of an area of the display device of FIGS. 2A and 2B. FIG. 7 is a cross-sectional view taken along the line I-I' of FIG. 6. For convenience of description, some of the components illustrated in FIG. 7 are omitted or emphasized in FIG. 6.

Referring to FIG. 6, the display device DD may include first to third pixel driving circuits, first to third light-emitting elements LDa, LDb, and LDc, first to third connection patterns CNPa, CNPb, and CNPc, and a separator SPR.

Each of the first to third pixel driving circuits may correspond to any one of the pixel driving circuits PC, PC', and PC" described above with reference to FIGS. 3A, 3D, 4A, and 5A. Each of the first to third pixel driving circuits may include at least one transistor and at least one capacitor. For example, each of the first to third pixel driving circuits may include a first transistor TR1, a second transistor TR2, a first capacitor CAP1, and a second capacitor CAP2 illustrated in FIG. 7.

The second transistor TR2 of FIG. 7 may be a transistor that is connected to a light-emitting element through a connection electrode and a connection pattern. For example, when the first to third pixel driving circuits are the pixel driving circuit PC" of FIG. 5A, the second transistor TR2 may be the fifth transistor T5 of FIG. 5A, and the first transistor TR1 may be the fourth transistor T4 or the seventh transistor T7 of FIG. 5A. However, the present disclosure is not necessarily limited thereto.

In some example embodiments, the first capacitor CAP1 of FIG. 7 may correspond to the first capacitor C1 of FIGS. 3A, 3D, 4A, and 5A, and the second capacitor CAP2 of FIG. 7 may correspond to the second capacitor C2 of FIGS. 3A, 3D, 4A, and 5A. However, the present disclosure is not necessarily limited thereto, and the first capacitor CAP1 of FIG. 7 may correspond to the second capacitor C2 of FIGS. 3A, 3D, 4A, and 5A, and the second capacitor CAP2 of FIG. 7 may correspond to the first capacitor C1 of FIGS. 3A, 3D, 4A, and 5A.

The components of the first transistor TR1, the second transistor TR2, the first capacitor CAP1, and the second capacitor CAP2 are described in more detail below with reference to FIG. 7.

The display device DD may include first to third light-emitting areas EAa, EAb, and EAc. The first to third light-emitting areas EAa, EAb, and EAc may be arranged in various shapes. In some example embodiments, as illustrated in FIG. 6, the first to third light-emitting areas EAa, EAb, and EAc may be arranged in a Pentile^{™} shape. However, the present disclosure is not necessarily limited thereto, and the first to third light-emitting areas EAa, EAb, and EAc may be arranged in an S-stripe shape or a Diamond Pixel^{™} shape.

The first to third light-emitting areas EAa, EAb, and EAc may be defined by pixel openings of a pixel defining layer (PDL, see FIG. 7) described below. That is, the first to third light-emitting areas EAa, EAb, and EAc may be areas where light is emitted by the light-emitting element. For example, the first light-emitting element LDa may be disposed in the first light-emitting area EAa, and the first light-emitting area EAa may be an area from which light is emitted by the first light-emitting element LDa. In addition, the second light-emitting element LDb may be disposed in the second light-emitting area EAb, and the second light-emitting area EAb may be an area where light is emitted by the second light-emitting element LDb. In addition, the third light-emitting element LDc may be disposed in the third light-emitting area EAc, and the third light-emitting area EAc may be an area where light is emitted by the third light-emitting element LDc.

The first to third light-emitting elements LDa, LDb, and LDc may be connected to the first to third pixel driving circuits, respectively. For example, the first light-emitting element LDa may be connected to the first pixel driving circuit, the second light-emitting element LDb may be connected to the second pixel driving circuit, and the third light-emitting element LDc may be connected to the third pixel driving circuit. Accordingly, the first pixel driving circuit and the first light-emitting element LDa may form one sub-pixel (e.g., the first sub-pixel). The second pixel driving circuit and the second light-emitting element LDb may form one sub-pixel (e.g., the second sub-pixel). The third pixel driving circuit and the third light-emitting element LDc may form one sub-pixel (e.g., the third sub-pixel).

The first to third light-emitting elements LDa, LDb, and LDc may emit light of different colors. For example, the first light-emitting element LDa may emit red light, the second light-emitting element LDb may emit green light, and the third light-emitting element LDc may emit blue light. However, the present disclosure is not necessarily limited thereto.

Each of the first to third light-emitting elements LDa, LDb, and LDc may correspond to the light-emitting element LD described above with reference to FIGS. 3A, 3D, 4A, and 5A. For example, each of the first to third light-emitting elements LDa, LDb, and LDc may include a first electrode (E1, see FIG. 7), a middle layer (ML, see FIG. 7) disposed on the first electrode E1, and an electrode layer (E2L, see FIG. 7) disposed on the middle layer ML. In some example embodiments, the first electrode E1 may function as the anode of FIGS. 3A, 3D, 4A, and 5A, and the electrode layer E2L may function as the cathode of FIGS. 3A, 3D, 4A, and 5A.

The separator SPR may be disposed between the first to third light-emitting areas EAa, EAb, and EAc in a plan view. For example, the separator SPR may be disposed between the first light-emitting area EAa and the second light-emitting area EAb, between the second light-emitting area EAb and the third light-emitting area EAc, and between the first light-emitting area EAa and the third light-emitting area EAc in a plan view. In some example embodiments, the separator SPR may entirely surround each of the first to third light-emitting areas EAa, EAb, and EAc in a plan view. In some example embodiments, the separator SPR may include an organic insulating material.

The separator SPR may separate (or disconnect) the electrode layer (E2L, see FIG. 7) into a plurality of second electrodes spaced apart from each other. For example, the electrode layer E2L may be separated (or disconnected) into a second electrode (E2, see FIG. 7) of the first light-emitting element LDa, a second electrode of the second light-emitting element LDb, and a second electrode of the third light-emitting element LDc. Accordingly, the second electrode E2 of the first light-emitting element LDa, the second electrode of the second light-emitting element LDb, and the second electrode of the third light-emitting element LDc may be spaced apart from each other. In addition, the second electrode E2 of the first light-emitting element LDa, the second electrode of the second light-emitting element LDb, and the second electrode of the third light-emitting element LDc may be electrically independent of each other.

The first connection pattern CNPa may connect the first light-emitting element LDa and the first pixel driving circuit, the second connection pattern CNPb may connect the second light-emitting element LDb and the second pixel driving circuit, and the third connection pattern CNPc may connect the third light-emitting element LDc the third pixel driving circuit.

In some example embodiments, the first to third connection patterns CNPa, CNPb, and CNPc may include a transparent conductive oxide. Examples of the transparent conductive oxide that may be used as the first to third connection patterns CNPa, CNPb, and CNPc may include indium gallium zinc oxide (IGZO), indium tin zinc oxide (ITZO), indium tin oxide (ITO), indium zinc oxide (IZO), indium gallium oxide (IGO), zinc oxide (ZnO), indium oxide (InO), tin oxide (SnO), gallium oxide (GaO), aluminum zinc oxide (AZO), or the like. They may be used alone or in combination with each other.

However, the present disclosure is not necessarily limited thereto, and the first to third connection patterns CNPa, CNPb, and CNPc may include a conductive material such as a metal, an alloy, a conductive metal nitride, or the like. Examples of the conductive material that may be used as the first to third connection patterns CNPa, CNPb, and CNPc may include gold (Au), silver (Ag), aluminum (Al), platinum (Pt), nickel (Ni), titanium (Ti), palladium (Pd), magnesium (Mg), calcium (Ca), lithium (Li), chromium (Cr), tantalum (Ta), tungsten (W), copper (Cu), molybdenum (Mo), and scandium (Sc), neodymium (Nd), iridium (Ir), an alloy containing aluminum (Al), an alloy containing silver (Ag), an alloy containing copper (Cu), an alloy containing molybdenum (Mo), aluminum nitride (AlN), tungsten nitride (WN), titanium nitride (TiN), chromium nitride (CrN), tantalum nitride (TaN), or the like. These may be used alone or in combination with each other.

In some example embodiments, the first to third connection patterns CNPa, CNPb, and CNPc may have a single-layer structure or a multi-layer structure in which a plurality of conductive layers are stacked.

The first connection pattern CNPa may be connected to a first connection electrode (CE, see FIG. 7). In some example embodiments, the first connection pattern CNPa may contact the first connection electrode CE through a first pattern contact hole TCNTa.

The first connection pattern CNPa may not overlap the first light-emitting area EAa in a plan view. In some example embodiments, the first connection pattern CNPa may surround at least a portion of the first light-emitting area EAa in a plan view. For example, the first connection pattern CNPa may have a closed ring shape that entirely surrounds the first light-emitting area EAa in a plan view. However, the present disclosure is not necessarily limited thereto.

The second electrode (E2, see FIG. 7) of the first light-emitting element LDa may be connected to the first connection pattern CNPa. For example, the second electrode E2 of the first light-emitting element LDa may contact the first connection pattern CNPa. Accordingly, the first connection pattern CNPa may electrically connect the first connection electrode (CE, see FIG. 7) and the second electrode E2 of the first light-emitting element LDa. As a result, the second electrode E2 of the first light-emitting element LDa may be electrically connected to the first pixel driving circuit through the first connection electrode CE and the first connection pattern CNPa.

In some example embodiments, a planar profile of an area where the second electrode E2 of the first light-emitting element LDa and the first connection pattern CNPa contact may be substantially identical or similar to a planar profile of an edge of the first connection pattern CNPa. For example, when the first connection pattern CNPa has a closed ring shape that entirely surrounds the first light-emitting area EAa in a plan view, the area where the second electrode E2 of the first light-emitting element LDa and the first connection pattern CNPa contact may have a closed ring shape in a plan view. That is, the second electrode E2 of the first light-emitting element LDa and the first connection pattern CNPa may contact at a position that does not overlap the first light-emitting area EAa. Accordingly, the second electrode E2 of the first light-emitting element LDa may be electrically connected to the first pixel driving circuit through the first connection electrode CE and the first connection pattern CNPa without reducing a size of the first light-emitting area EAa.

The second connection pattern CNPb may be connected to a second connection electrode. In some example embodiments, the second connection pattern CNPb may contact the second connection electrode through a second pattern contact hole TCNTb. In some example embodiments, the first connection electrode CE and the second connection electrode may be spaced apart from each other in a plan view. That is, the first connection electrode CE and the second connection electrode may be electrodes that are distinct from each other.

The second connection pattern CNPb may not overlap the second light-emitting area EAb in a plan view. In some example embodiments, the second connection pattern CNPb may surround at least a portion of the second light-emitting area EAb in a plan view. For example, the second connection pattern CNPb may have a closed ring shape that entirely surrounds the second light-emitting area EAb in a plan view. However, the present disclosure is not necessarily limited thereto.

The second electrode of the second light-emitting element LDb may be connected to the second connection pattern CNPb. For example, the second electrode of the second light-emitting element LDb may contact the second connection pattern CNPb. Accordingly, the second connection pattern CNPb may electrically connect the second connection electrode and the second electrode of the second light-emitting element LDb. As a result, the second electrode of the second light-emitting element LDb may be electrically connected to the second pixel driving circuit through the second connection electrode and the second connection pattern CNPb.

In some example embodiments, a planar profile of an area where the second electrode of the second light-emitting element LDb and the second connection pattern CNPb contact may be substantially identical or similar to a planar profile of an edge of the second connection pattern CNPb. For example, when the second connection pattern CNPb has a closed ring shape that entirely surrounds the second light-emitting area EAb in a plan view, the area where the second electrode of the second light-emitting element LDb and the second connection pattern CNPb contact may have a closed ring shape in a plan view. That is, the second electrode of the second light-emitting element LDb and the second connection pattern CNPb may contact at a position that does not overlap the second light-emitting area EAb. Accordingly, the second electrode of the second light-emitting element LDb may be electrically connected to the second pixel driving circuit through the second connection electrode and the second connection pattern CNPb without reducing a size of the second light-emitting area EAb.

The third connection pattern CNPc may be connected to a third connection electrode. In some example embodiments, the third connection pattern CNPc may contact the third connection electrode through a third pattern contact hole TCNTc. In some example embodiments, the first connection electrode CE, the second connection electrode, and the third connection electrode may be spaced apart from each other in a plan view. That is, the first connection electrode CE, the second connection electrode, and the third connection electrode may be electrodes that are distinct from each other.

The third connection pattern CNPc may not overlap the third light-emitting area EAc in a plan view. In some example embodiments, the third connection pattern CNPc may surround at least a portion of the third light-emitting area EAc in a plan view. For example, the third connection pattern CNPc may have a closed ring shape that entirely surrounds the third light-emitting area EAc in a plan view. However, the present disclosure is not necessarily limited thereto.

The second electrode of the third light-emitting element LDc may be connected to the third connection pattern CNPc. For example, the second electrode of the third light-emitting element LDc may contact the third connection pattern CNPc. Accordingly, the third connection pattern CNPc may electrically connect the third connection electrode and the second electrode of the third light-emitting element LDc. As a result, the second electrode of the third light-emitting element LDc may be electrically connected to the third pixel driving circuit through the third connection electrode and the third connection pattern CNPc.

In some example embodiments, a planar profile of an area where the second electrode of the third light-emitting element LDc and the third connection pattern CNPc contact may be substantially identical or similar to a planar profile of an edge of the third connection pattern CNPc. For example, when the third connection pattern CNPc has a closed ring shape that entirely surrounds the third light-emitting area EAc in a plan view, the area where the second electrode of the third light-emitting element LDc and the third connection pattern CNPc contact may have a closed ring shape in a plan view. That is, the second electrode of the third light-emitting element LDc and the third connection pattern CNPc may contact at a position that does not overlap the third light-emitting area EAc. Accordingly, the second electrode of the third light-emitting element LDc may be electrically connected to the third pixel driving circuit through the third connection electrode and the third connection pattern CNPc without reducing a size of the third light-emitting area EAc.

As described above, the display device DD may include the separator SPR. The separator SPR may overlap the first to third connection patterns CNPa, CNPb, and CNPc in a plan view. For example, the separator SPR may cover a portion of the first to third connection patterns CNPa, CNPb, and CNPc. That is, at least a portion of the separator SPR may extend along edges of the first to third connection patterns CNPa, CNPb, and CNPc in a plan view. Thus, the areas where the second electrodes of the first to third light-emitting elements LDa, LDb, and LDc and the first to third connection patterns CNPa, CNPb, and CNPc contact may be adjacent to or overlap an area where the separator SPR is disposed in a plan view.

The separator SPR may define first to third open areas OA1, OA2, and OA3. For example, the separator SPR may have a mesh structure surrounding the second electrodes in a plan view. The second electrode E2 of the first light-emitting element LDa may be disposed in the first open area OA1 of the separator SPR, the second electrode of the second light-emitting element LDb may be disposed in the second open area OA2 of the separator SPR, and the second electrode of the third light-emitting element LDc may be disposed in the third open area OA3 of the separator SPR.

The first to third open areas OA1, OA2, and OA3 of the separator SPR may correspond to the first to third connection patterns CNPa, CNPb, and CNPc, respectively. For example, the first connection pattern CNPa may overlap the first open area OA1, the second connection pattern CNPb may overlap the second open area OA2, and the third connection pattern CNPc may overlap the third open area OA3.

Hereinafter, the cross-sectional structure of the display device DD will be described in more detail with reference to FIG. 7, focusing on the first light-emitting area EAa. The following descriptions of the cross-sectional structure of the display device DD may be equally (or similarly) applied to all light-emitting areas.

Referring further to FIG. 7, the display device DD may include a substrate SUB, a circuit element layer PCL, a pixel defining layer PDL, the first connection pattern CNPa, the first light-emitting element LDa, the separator SPR, a first dummy layer DP1, a second dummy layer DP2, and/or an encapsulation layer ENC. The circuit element layer PCL may include the first transistor TR1, the second transistor TR2, the first capacitor CAP1, the second capacitor CAP2, the first connection electrode CE, and/or first to seventh insulating layers IL1, IL2, IL3, IL4, IL5, IL6, and IL7.

The first transistor TR1 may include a lower active pattern PACT, a first gate electrode GE1, a first contact electrode SE1, and a second contact electrode DE1. The second transistor TR2 may include an upper active pattern OACT, a second gate electrode GE2, a third contact electrode SE2, and a fourth contact electrode DE2. The first capacitor CAP1 may include a first capacitor electrode CPE1 and a third capacitor electrode CPE3. The second capacitor CAP2 may include a second capacitor electrode CPE2 and a fourth capacitor electrode CPE4. The first light-emitting element LDa may include a first electrode E1, a middle layer ML, and a second electrode E2.

As described above, the first transistor TR1, the second transistor TR2, the first capacitor CAP1, and the second capacitor CAP2 may be components included in the first pixel driving circuit.

The lower active pattern PACT may be disposed on the substrate SUB. In some example embodiments, the lower active pattern PACT may include a silicon semiconductor material. Examples of the silicon semiconductor material may include amorphous silicon, polycrystalline silicon, or the like. The lower active pattern PACT may include a first contact area S1, a second contact area D1, and a first channel area CH1 between the first contact area S1 and the second contact area D1. The first contact area S1 and the second contact area D1 may have a conductivity higher than a conductivity of the first channel area CH1.

The first insulating layer IL1 may be disposed on the substrate SUB. The first insulating layer IL1 may cover the lower active pattern PACT on the substrate SUB. The first insulating layer IL1 may include an insulating material. Examples of the insulating material that may be used as the first insulating layer IL1 may include silicon oxide (SiOₓ), silicon nitride (SiNₓ), silicon oxynitride (SiOₓN_{y}), or the like. These may be used alone or in combination with each other.

The first gate electrode GE1 may be disposed on the lower active pattern PACT. For example, the first gate electrode GE1 may be disposed on the first insulating layer IL1. The first gate electrode GE1 may overlap the first channel area CH1 of the lower active pattern PACT. The first gate electrode GE1 may include a conductive material such as a metal, an alloy, a conductive metal oxide, a conductive metal nitride, a transparent conductive oxide, or the like.

The first capacitor electrode CPE1 and the second capacitor electrode CPE2 may be disposed on the first insulating layer IL1. The first capacitor electrode CPE1 and the second capacitor electrode CPE2 may be spaced apart from each other. The first capacitor electrode CPE1 and the second capacitor electrode CPE2 may include a conductive material such as a metal, an alloy, a conductive metal oxide, a conductive metal nitride, a transparent conductive oxide, or the like.

The second insulating layer IL2 may be disposed on the first insulating layer IL1. The second insulating layer IL2 may cover the first gate electrode GE1, the first capacitor electrode CPE1, and the second capacitor electrode CPE2 on the first insulating layer IL1. The second insulating layer IL2 may include an insulating material. Examples of the insulating material that may be used as the second insulating layer IL2 may include silicon oxide (SiOₓ), silicon nitride (SiNₓ), silicon oxynitride (SiOₓN_{y}), or the like. These may be used alone or in combination with each other.

The third capacitor electrode CPE3 and the fourth capacitor electrode CPE4 may be disposed on the second insulating layer IL2. The third capacitor electrode CPE3 and the fourth capacitor electrode CPE4 may be spaced apart from each other. The third capacitor electrode CPE3 may overlap the first capacitor electrode CPE1 in a plan view. The first capacitor electrode CPE1 and the third capacitor electrode CPE3 may form the first capacitor CAP1. The fourth capacitor electrode CPE4 may overlap the second capacitor electrode CPE2 in a plan view. The second capacitor electrode CPE2 and the fourth capacitor electrode CPE4 may form the second capacitor CAP2. The third capacitor electrode CPE3 and the fourth capacitor electrode CPE4 may include a conductive material such as a metal, an alloy, a conductive metal oxide, a conductive metal nitride, a transparent conductive oxide, or the like.

The third insulating layer IL3 may be disposed on the second insulating layer IL2. The third insulating layer IL3 may cover the third capacitor electrode CPE3 and the fourth capacitor electrode CPE4 on the second insulating layer IL2. The third insulating layer IL3 may include an insulating material. Examples of the insulating material that may be used as the third insulating layer IL3 may include silicon oxide (SiOₓ), silicon nitride (SiNₓ), silicon oxynitride (SiOₓN_{y}), or the like. These may be used alone or in combination with each other.

The upper active pattern OACT may be disposed between the first gate electrode GE1 and the first contact electrode SE1. For example, the upper active pattern OACT may be disposed on the third insulating layer IL3. In some example embodiments, the upper active pattern OACT and the lower active pattern PACT may include different materials. For example, the upper active pattern OACT may include an oxide semiconductor material. Examples of the oxide semiconductor material may include indium gallium zinc oxide (IGZO), zinc tin oxide (ZTO), and indium tin zinc oxide (ITZO), or the like. They may be used alone or in combination with each other.

The upper active pattern OACT may include a third contact area S2, a fourth contact area D2, and a second channel area CH2 between the third contact area S2 and the fourth contact area D2. The third contact area S2 and the fourth contact area D2 may have a conductivity higher than a conductivity of the second channel area CH2.

The fourth insulating layer IL4 may be disposed on the third insulating layer IL3. The fourth insulating layer IL4 may cover the upper active pattern OACT on the third insulating layer IL3. The fourth insulating layer IL4 may include an insulating material. Examples of the insulating material that may be used as the fourth insulating layer IL4 may include silicon oxide (SiOₓ), silicon nitride (SiNₓ), silicon oxynitride (SiOₓN_{y}), or the like. These may be used alone or in combination with each other.

The second gate electrode GE2 may be disposed on the upper active pattern OACT. For example, the second gate electrode GE2 may be disposed on the fourth insulating layer IL4. The second gate electrode GE2 may overlap the second channel area CH2 of the upper active pattern OACT. The second gate electrode GE2 may include a conductive material such as a metal, an alloy, a conductive metal oxide, a conductive metal nitride, a transparent conductive oxide, or the like.

The fifth insulating layer IL5 may be disposed on the fourth insulating layer IL4. The fifth insulating layer IL5 may cover the second gate electrode GE2 on the fourth insulating layer IL4. The fifth insulating layer IL5 may include an insulating material. Examples of the insulating material that may be used as the fifth insulating layer IL5 may include silicon oxide (SiOₓ), silicon nitride (SiNₓ), silicon oxynitride (SiOₓN_{y}), or the like. These may be used alone or in combination with each other.

The first to fourth contact electrodes SE1, DE1, SE2, and DE2 may be disposed on the fifth insulating layer IL5. The first contact electrode SE1 may contact the first contact area S1 of the lower active pattern PACT, and the second contact electrode DE1 may contact the second contact area D1 of the lower active pattern PACT. The third contact electrode SE2 may contact the third contact area S2 of the upper active pattern OACT, and the fourth contact electrode DE2 may contact the fourth contact area D2 of the upper active pattern OACT. In some example embodiments, the third contact electrode SE2 may contact the first capacitor electrode CPE1. However, the present disclosure is not necessarily limited thereto. The first to fourth contact electrodes SE1, DE1, SE2, and DE2 may include a conductive material such as a metal, an alloy, a conductive metal oxide, a conductive metal nitride, a transparent conductive oxide, or the like.

The sixth insulating layer IL6 may be disposed on the fifth insulating layer IL5. The sixth insulating layer IL6 may cover the first to fourth contact electrodes SE1, DE1, SE2, and DE2 on the fifth insulating layer IL5. The sixth insulating layer IL6 may include an insulating material. For example, the sixth insulating layer IL6 may include an organic insulating material. Examples of the organic insulating material that may be used as the sixth insulating layer IL6 may include a polyacryl-based resin, a polyimide-based resin, a polyamide-based resin, a siloxane-based resin, an acrylic-based resin, an epoxy-based resin, or the like. These may be used alone or in combination with each other.

The first connection electrode CE may be disposed on the sixth insulating layer IL6. The first connection electrode CE may be connected to the second transistor TR2. For example, the first connection electrode CE may contact the second transistor TR2 (e.g., the fourth contact electrode DE2) through a contact hole penetrating the sixth insulating layer IL6. The first connection electrode CE may include a conductive material such as a metal, an alloy, a conductive metal oxide, a conductive metal nitride, a transparent conductive oxide, or the like. In some example embodiments, the first connection electrode CE may have a single-layer structure or a multi-layer structure in which a plurality of conductive layers are stacked.

The seventh insulating layer IL7 may partially cover the first connection electrode CE and may be disposed on the sixth insulating layer IL6. The seventh insulating layer IL7 may define a first sub-opening SO1 exposing at least a portion of the first connection electrode CE. The seventh insulating layer IL7 may include an insulating material. For example, the seventh insulating layer IL7 may include an organic insulating material. Examples of the organic insulating material that may be used as the seventh insulating layer IL7 may include a polyacryl-based resin, a polyimide-based resin, a polyamide-based resin, a siloxane-based resin, an acrylic-based resin, an epoxy-based resin, or the like. These may be used alone or in combination with each other.

The first electrode E1 may be disposed on the seventh insulating layer IL7. The first electrode E1 may be spaced apart from the first connection electrode CE. The first electrode E1 may include a conductive material such as a metal, an alloy, a conductive metal oxide, a conductive metal nitride, a transparent conductive oxide, or the like. As described above, the first electrode E1 may function as the anode of FIGS. 3A, 3D, 4A, and 5A.

The pixel defining layer PDL may be disposed on the seventh insulating layer IL7 and the first electrode E1. The pixel defining layer PDL may define a pixel opening exposing a portion of the first electrode E1. The first light-emitting area EAa may be defined by the pixel opening.

In addition, the pixel defining layer PDL may further define a second sub-opening SO2 corresponding to the first sub-opening SO1 of the seventh insulating layer IL7. The second sub-opening SO2 may overlap the first sub-opening SO1 in a plan view. The first sub-opening SO1 and the second sub-opening SO2 may be spatially connected to each other. That is, a sub-opening OP may be defined where the first sub-opening SO1 and the second sub-opening SO2 are connected, and the sub-opening OP may expose a portion of the first connection electrode CE.

The first connection pattern CNPa may be disposed on the first connection electrode CE, the seventh insulating layer IL7, and the pixel defining layer PDL. The first connection pattern CNPa may be connected to the first connection electrode CE. For example, the first connection pattern CNPa may contact the first connection electrode CE through the sub-opening OP (or the first pattern contact hole TCNTa) penetrating the seventh insulating layer IL7 and the pixel defining layer PDL.

In some example embodiments, the first connection pattern CNPa may include a transparent conductive oxide. However, the present disclosure is not necessarily limited thereto, and the first connection pattern CNPa may include a conductive material such as a metal, an alloy, a conductive metal nitride, or the like. In some example embodiments, the first connecting pattern CNPa may have a single-layer structure or a multi-layer structure in which a plurality of conductive layers are stacked.

The separator SPR may be disposed on the pixel defining layer PDL and the first connection pattern CNPa. The separator SPR may overlap the first connection pattern CNPa in a plan view. For example, the separator SPR may cover a portion of the first connection pattern CNPa.

A width of an upper portion of the separator SPR may be greater than a width of a lower portion of the separator SPR. That is, a side surface of the separator SPR connecting an upper surface of the separator SPR and a lower surface of the separator SPR may have a reverse tapered slope. In other words, a cross-section of at least a portion of the separator SPR may be an inverse trapezoid.

In some example embodiments, as illustrated in FIG. 7, the side surface of the separator SPR may have a plurality of reverse tapered slopes. That is, the separator SPR may have a double reverse tapered structure. Accordingly, the separation (or disconnection) of the electrode layer E2L by the separator SPR may be more easily implemented.

The middle layer ML may be disposed on the first electrode E1, the pixel defining layer PDL, and the first connection pattern CNPa. A portion of the middle layer ML may be disposed in the pixel opening of the pixel defining layer PDL. In some example embodiments, the middle layer ML may include a first functional layer including an organic material, a light-emitting layer disposed on the first functional layer and including a light-emitting material, and a second functional layer disposed on the light-emitting layer and including an organic material. For example, the first functional layer may include a hole injection layer, a hole transport layer, or the like, and the second functional layer may include an electron transport layer, an electron injection layer, or the like.

Around the separator SPR having a reverse tapered slope, a shadow area may exist in which the middle layer ML is difficult to be deposited. Accordingly, in the shadow area and/or in a periphery of the shadow area, the middle layer ML may have a structure that is separated (or disconnected) by the separator SPR. For example, the first functional layer and the second functional layer included in the middle layer ML may have a structure separated (or disconnected) by the separator SPR. As the middle layer ML has a separated (or disconnected) structure, the middle layer ML may not entirely cover the first connection pattern CNPa. That is, the middle layer ML may expose a portion of the first connection pattern CNPa at a position adjacent to or overlapping the separator SPR. Accordingly, the second electrode E2 of the first light-emitting element LDa may contact the first connection pattern CNPa.

The first dummy layer DP1 may be disposed on the separator SPR. The first dummy layer DP1 may be formed as the middle layer ML has a structure that is separated (or disconnected) by the separator SPR. That is, the first dummy layer DP1 may be formed in the same process as (or a similar process to) the middle layer ML. In some example embodiments, the first dummy layer DP 1 may be omitted.

The electrode layer E2L may be disposed on the middle layer ML. The electrode layer E2L may include a conductive material such as a metal, an alloy, a conductive metal oxide, a conductive metal nitride, a transparent conductive oxide, or the like. In some example embodiments, the electrode layer E2L may have a single-layer structure. However, the present disclosure is not necessarily limited thereto, and the electrode layer E2L may have a multi-layer structure in which a plurality of conductive layers are stacked. For example, the electrode layer E2L may have a two-layer structure in which a first sub-electrode layer including a metal and a second sub-electrode layer disposed on the first sub-electrode layer and including a transparent conductive oxide are stacked.

Around the separator SPR having a reverse tapered slope, the shadow area may exist in which the electrode layer E2L is difficult to be deposited. Accordingly, in the shadow area and/or in a periphery of the shadow area, the electrode layer E2L may have a structure that is separated (or disconnected) by the separator SPR. For example, as illustrated in FIGS. 6 and 7, the electrode layer E2L may be separated (or disconnected) into the second electrode E2 of the first light-emitting element LDa disposed in the first open area OA1 of the separator SPR, the second electrode of the second light-emitting element LDb disposed in the second open area OA2 of the separator SPR, and the second electrode of the third light-emitting element LDc disposed in the third open area OA3 of the separator SPR. That is, the second electrodes may be electrically independent of each other.

As illustrated in FIG. 7, the second electrode E2 of the first light-emitting element LDa may be connected to the first connection pattern CNPa. For example, the second electrode E2 may contact the first connection pattern CNPa at a positioned adjacent to or overlapping the separator SPR. For example, when a deposition angle of the deposition process forming the electrode layer E2L is greater than a deposition angle of the deposition process forming the middle layer ML, the electrode layer E2L (specifically, the second electrode E2) may be formed to contact the first connection pattern CNPa while covering a disconnected side portion of the middle layer ML. As a result, the second electrode E2 may be electrically connected to the second transistor TR2 through the first connection electrode CE and the first connection pattern CNPa.

The second dummy layer DP2 may be disposed on the separator SPR. For example, the second dummy layer DP2 may be disposed on the first dummy layer DP1. The second dummy layer DP2 may be formed as the electrode layer E2L has a structure that is separated (or disconnected) by the separator SPR. That is, the second dummy layer DP2 may be formed in the same process as (or a similar process to) the electrode layer E2L. In some example embodiments, the second dummy layer DP2 may be omitted.

The encapsulation layer ENC may be disposed on the electrode layer E2L. The encapsulation layer ENC may entirely cover the electrode layer E2L, the first connection pattern CNPa, the separator SPR, the first dummy layer DP1, and the second dummy layer DP2. In some example embodiments, the encapsulation layer ENC may include a first inorganic encapsulation layer IEL1 including an inorganic insulating material, an organic encapsulation layer OEL disposed on the first inorganic encapsulation layer IEL1 and including an organic insulating material, and a second inorganic encapsulation layer IEL2 disposed on the organic encapsulation layer OEL and including an inorganic insulating material.

In some example embodiments, the display device DD may further include a touch sensing layer disposed on the encapsulation layer ENC. For example, the touch sensing layer may include a plurality of touch electrode arrays for sensing a user's touch in a capacitive manner, a touch pad portion, and a plurality of touch lines electrically connecting the touch electrode arrays and the touch pad portion. However, the present disclosure is not necessarily limited thereto. In some example embodiments, the touch sensing layer may be omitted.

According to some example embodiments, the display device DD may include a connection electrode (e.g., the first connection electrode CE), a connection pattern (e.g., the first connection pattern CNPa), and the separator SPR. Accordingly, the electrode layer E2L (e.g., a cathode) disposed on the first electrode E1 (e.g., an anode) may be easily connected to a pixel driving circuit. For example, the electrode layer E2L disposed on the first electrode E1 may be connected to a drain of a driving transistor (e.g., the first transistor T1 of FIGS. 3A, 3D, 4A, and 5A) of the pixel driving circuit through the connection electrode and the connection pattern. Accordingly, the gate-source voltage (Vgs) of the driving transistor may not change even when a light-emitting element deteriorates. Accordingly, a range of change in the driving current due to the deterioration of the light-emitting element may be reduced. Accordingly, the afterimage defects of the display device DD due to increased usage time may be reduced, and the lifetime of the display device DD may be improved (e.g., increased).

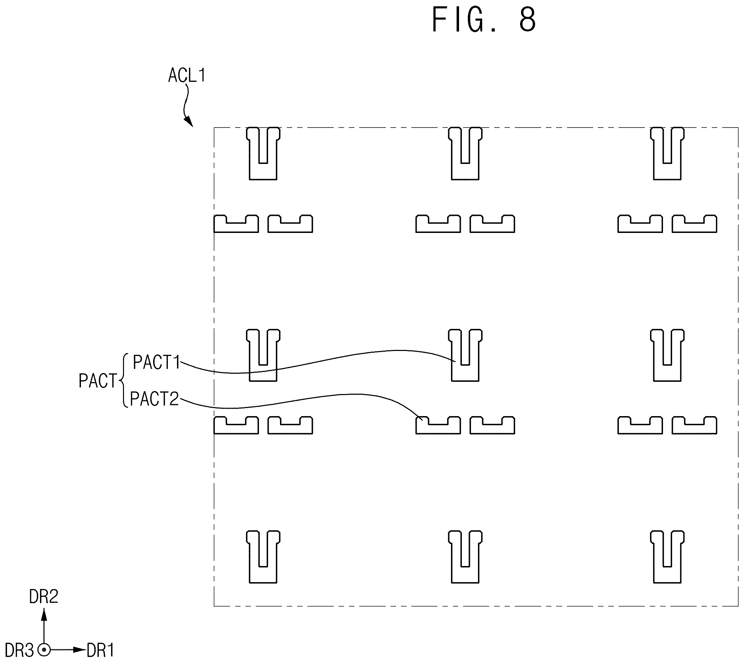

FIGS. 8, 9, 10, 11, 12, 13, 14, 15, 16, 17, 18, 19, and 20 are layout views illustrating an example of a pixel included in the display device of FIG. 1. For example, FIGS. 8 to 20 are layout views illustrating the circuit element layer PCL of FIG. 7 including the pixel driving circuit PC" of FIG. 5A.

FIG. 8 is a layout view illustrating a lower active layer ACL1.

Referring to FIGS. 5A, 7, and 8, the lower active layer ACL1 may be disposed on the substrate SUB. In some example embodiments, the lower active layer ACL1 may include a silicon semiconductor material.

The lower active layer ACL1 may include the lower active pattern PACT, and the lower active pattern PACT may include a first lower active pattern PACT1 and a second lower active pattern PACT2. The first lower active pattern PACT1 and the second lower active pattern PACT2 may be spaced apart from each other. The first lower active pattern PACT1 may include a channel of the seventh transistor T7 included in the pixel driving circuit PC''. The second lower active pattern PACT2 may include a channel of the fourth transistor T4 included in the pixel driving circuit PC".

The first insulating layer IL1 may be disposed on the substrate SUB. The first insulating layer IL1 may cover the first lower active pattern PACT1 and the second lower active pattern PACT2 on the substrate SUB.

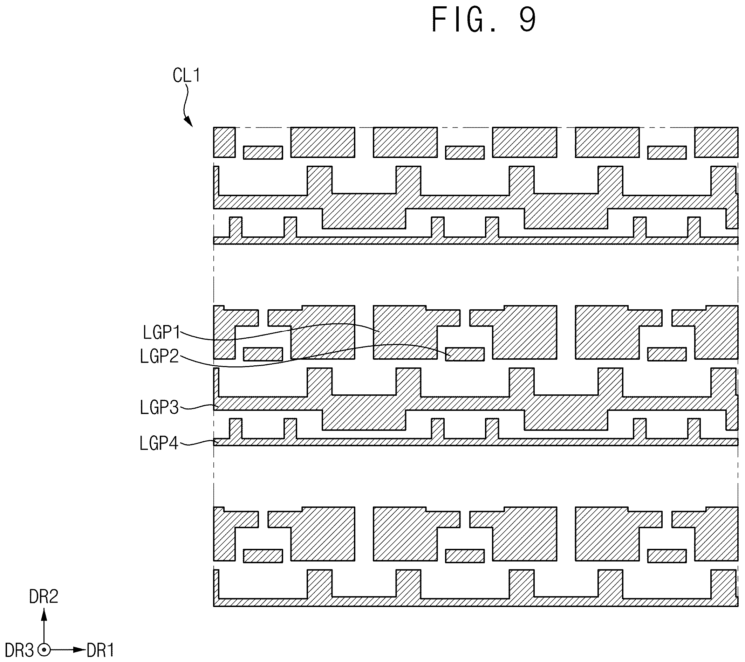

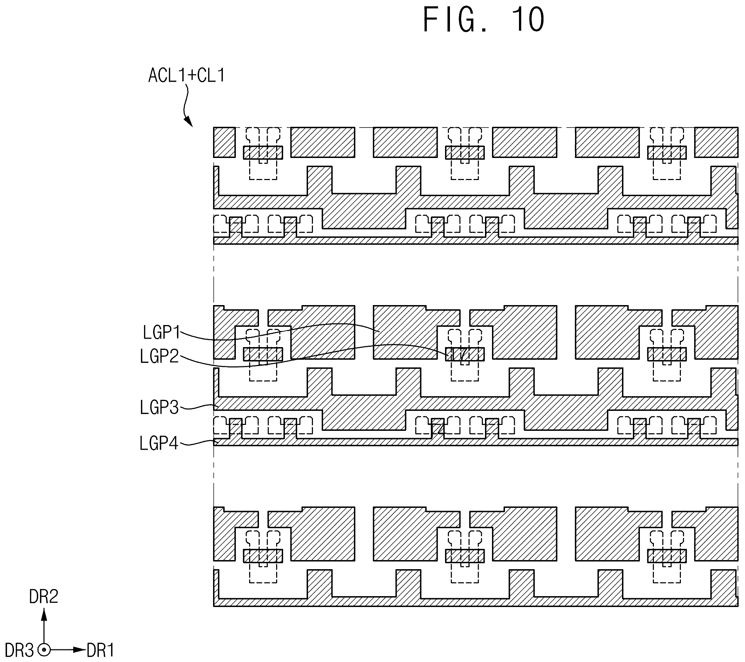

FIG. 9 is a layout view illustrating a first conductive layer CL1. FIG. 10 is a layout view in which the first conductive layer CL1 is further disposed on the lower active layer ACL1 of FIG. 9.

Referring further to FIGS. 9 and 10, the first conductive layer CL1 may be disposed on the lower active layer ACL1. For example, the first conductive layer CL1 may be disposed on the first insulating layer IL1. The first conductive layer CL1 may include a conductive material such as a metal, an alloy, a conductive metal oxide, a conductive metal nitride, a transparent conductive oxide, or the like. For example, the first conductive layer CL1 may be referred to as a first gate conductive layer.

The first conductive layer CL1 may include first to fourth lower gate patterns LGP1, LGP2, LGP3, and LGP4. The first to fourth lower gate patterns LGP1, LGP2, LGP3, and LGP4 may be spaced apart from each other in a plan view. The first to fourth lower gate patterns LGP1, LGP2, LGP3, and LGP4 may be disposed in the same layer as (or a similar layer to) the first gate electrode GE1 of FIG. 7.

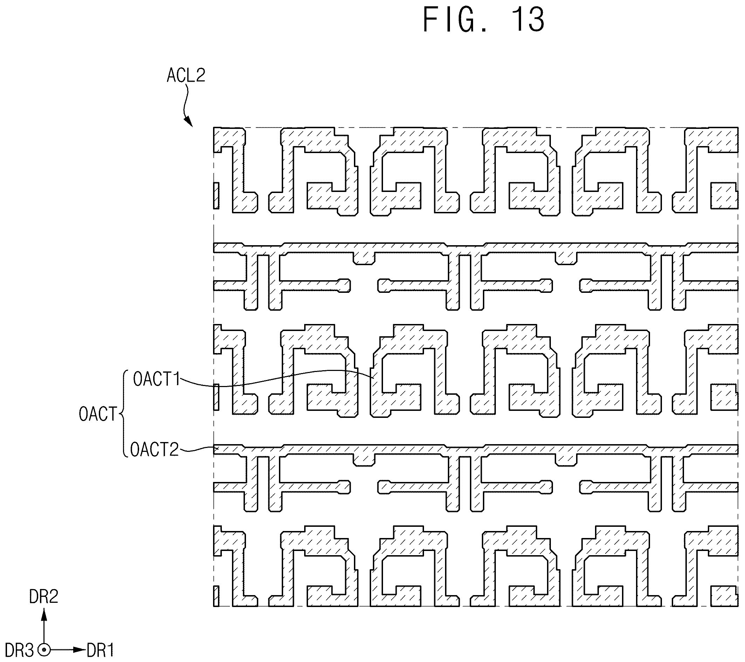

The first lower gate pattern LGP1 may overlap a first upper active pattern (OACT1, see FIG. 13) described below in a plan view. A portion of the first lower gate pattern LGP1 overlapping the first upper active pattern OACT1 may form the first transistor T1. The portion of the first lower gate pattern LGP1 overlapping the first upper active pattern OACT1 may be a lower gate electrode of the first transistor T1.

The second lower gate pattern LGP2 may overlap the first lower active pattern PACT1 in a plan view. A portion of the second lower gate pattern LGP2 overlapping the first lower active pattern PACT1 may form the seventh transistor T7. The portion of the second lower gate pattern LGP2 overlapping the first lower active pattern PACT1 may be a gate electrode of the seventh transistor T7. The second lower gate pattern LGP2 may receive the second emission control signal EM2.

The third lower gate pattern LGP3 may extend in the first direction DR1. The third lower gate pattern LGP3 may receive the second power voltage ELVSS. For example, the third lower gate pattern LGP3 may correspond to the second voltage line VL2 of FIG. 5A. For example, the third lower gate pattern LGP3 may be referred to as a first common voltage line.

The fourth lower gate pattern LGP4 may extend in the first direction DR1. The fourth lower gate pattern LGP4 may overlap the second lower active pattern PACT2 in a plan view. A portion of the fourth lower gate pattern LGP4 overlapping the second lower active pattern PACT2 may form the fourth transistor T4. The portion of the fourth lower gate pattern LGP4 overlapping the second lower active pattern PACT2 may be a gate electrode of the fourth transistor T4. The fourth lower gate pattern LGP4 may receive the third gate signal GC. For example, the fourth lower gate pattern LGP4 may correspond to the third gate line GCL of FIG. 5A.

The second insulating layer IL2 may be disposed on the first insulating layer IL1. The second insulating layer IL2 may cover the first to fourth lower gate patterns LGP1, LGP2, LGP3, and LGP4 on the first insulating layer IL1.

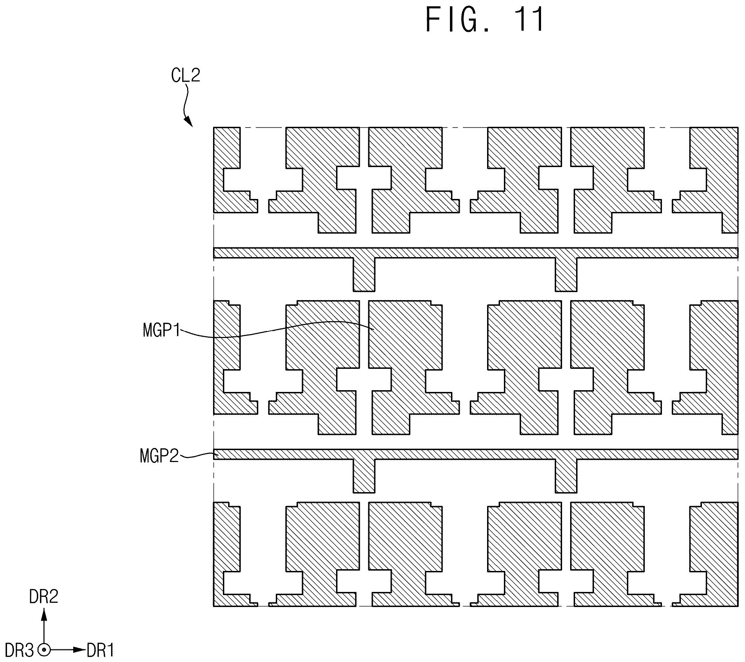

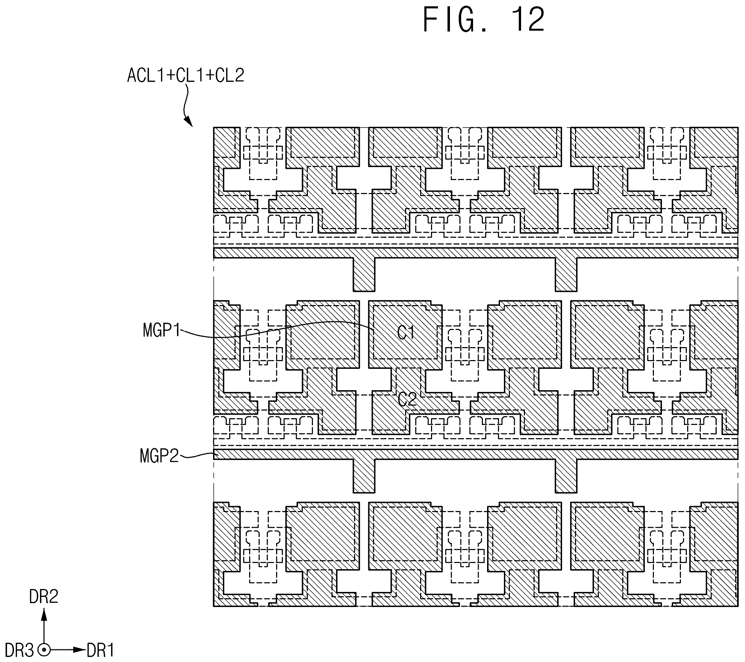

FIG. 11 is a layout view illustrating a second conductive layer CL2. FIG. 12 is a layout view in which the second conductive layer CL2 is further disposed on the first conductive layer CL1 of FIG. 10.

Referring further to FIGS. 11 and 12, the second conductive layer CL2 may be disposed on the first conductive layer CL1. For example, the second conductive layer CL2 may be disposed on the second insulating layer IL2. The second conductive layer CL2 may include a conductive material such as a metal, an alloy, a conductive metal oxide, a conductive metal nitride, a transparent conductive oxide, or the like. For example, the second conductive layer CL2 may be referred to as a second gate conductive layer.

The second conductive layer CL2 may include a first middle gate pattern MGP1 and a second middle gate pattern MGP2. The first middle gate pattern MGP1 and the second middle gate pattern MGP2 may be spaced apart from each other in a plan view. The first middle gate pattern MGP1 and the second middle gate pattern MGP2 may be disposed in the same layer as (or a similar layer to) the third capacitor electrode CPE3 of FIG. 7.

A first portion of the first middle gate pattern MGP1 may overlap the first lower gate pattern LGP1 in a plan view. The first portion of the first middle gate pattern MGP1 may be spaced apart from the first lower gate pattern LGP1 by the second insulating layer IL2. The first lower gate pattern LGP1 and the first portion of the first middle gate pattern MGP1 may form the first capacitor C1. For example, the first lower gate pattern LGP1 may correspond to the first capacitor electrode CPE1 of FIG. 7, and the first portion of the first middle gate pattern MGP1 may correspond to the third capacitor electrode CPE3 of FIG. 7.

A second portion of the first middle gate pattern MGP1 may overlap the third lower gate pattern LGP3 in a plan view. The second portion of the first middle gate pattern MGP1 may be spaced apart from the third lower gate pattern LGP3 by the second insulating layer IL2. The third lower gate pattern LGP3 and the second portion of the first middle gate pattern MGP1 may form the second capacitor C2. For example, the third lower gate pattern LGP3 may correspond to the second capacitor electrode CPE2 of FIG. 7, and the second portion of the first middle gate pattern MGP1 may correspond to the fourth capacitor electrode CPE4 of FIG. 7.

The second middle gate pattern MGP2 may extend in the first direction DR1. The second middle gate pattern MGP2 may receive the reference voltage VREF. For example, the second middle gate pattern MGP2 may correspond to the third voltage gate line VL3 of FIG. 5A.

The third insulating layer IL3 may be disposed on the second insulating layer IL2. The third insulating layer IL3 may cover the first middle gate pattern MGP1 and the second middle gate pattern MGP2 on the second insulating layer IL2.

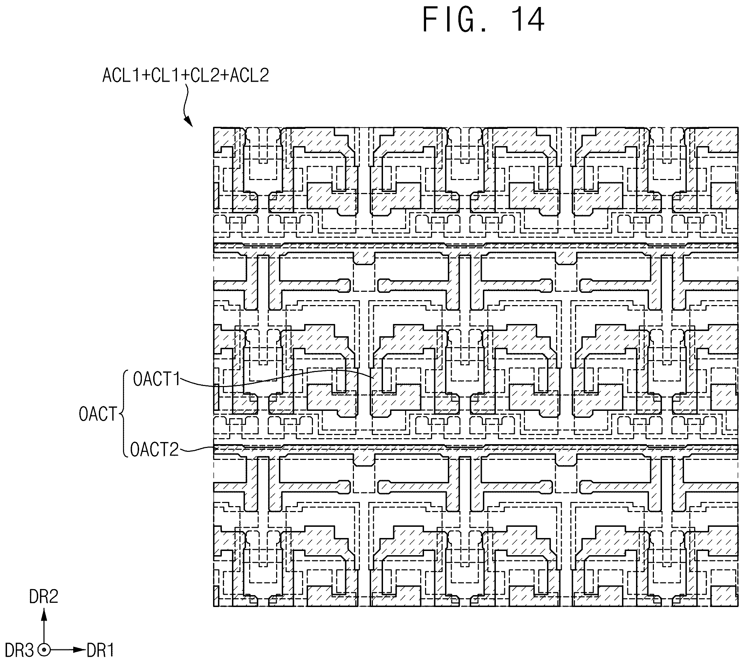

FIG. 13 is a layout view illustrating an upper active layer ACL2. FIG. 14 is a layout view in which the upper active layer ACL2 is further disposed on the second conductive layer CL2 of FIG. 12.

Referring further to FIGS. 13 and 14, the upper active layer ACL2 may be disposed on the second conductive layer CL2. For example, the upper active layer ACL2 may be disposed on the third insulating layer IL3. In some example embodiments, the upper active layer ACL2 may include an oxide semiconductor material.

The upper active layer ACL2 may include the upper active pattern OACT, and the upper active pattern OACT may include a first upper active pattern OACT1 and a second upper active pattern OACT2. The first upper active pattern OACT1 and the second upper active pattern OACT2 may be spaced apart from each other. The first upper active pattern OACT1 may include a channel of the first transistor T1, a channel of the fifth transistor T5, and a channel of the sixth transistor T6. The second upper active pattern OACT2 may include a channel of the second transistor T2 and a channel of the third transistor T3.

The fourth insulating layer IL4 may be disposed on the third insulating layer IL3. The fourth insulating layer IL4 may cover the first upper active pattern OACT1 and the second upper active pattern OACT2 on the third insulating layer IL3.

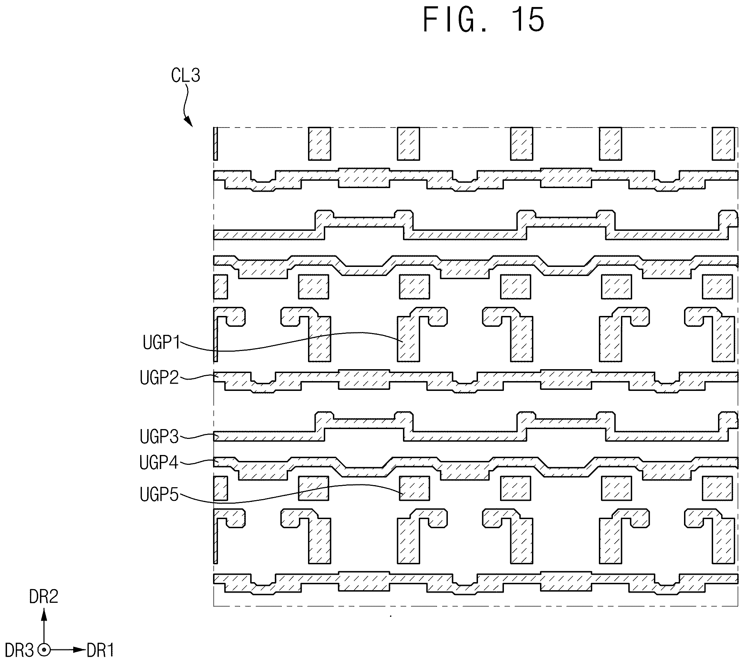

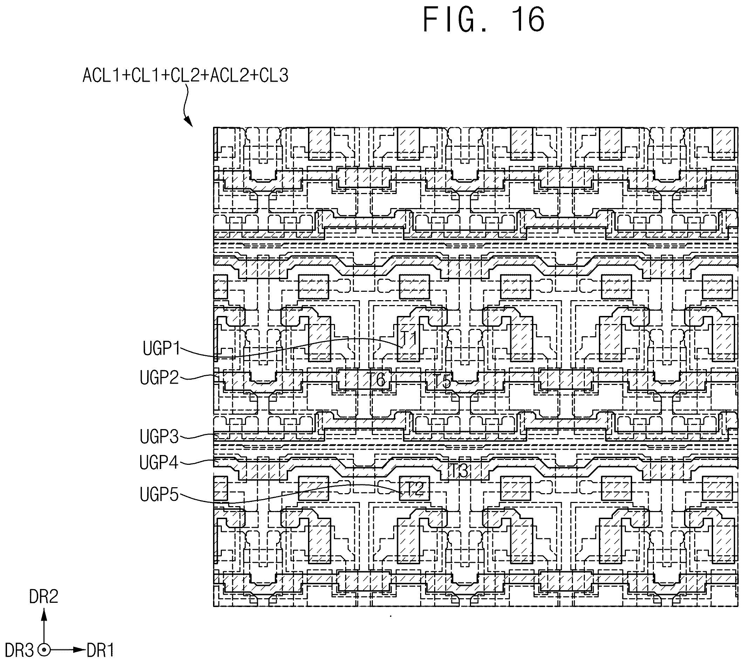

FIG. 15 is a layout view illustrating a third conductive layer CL3. FIG. 16 is a layout view in which the third conductive layer CL3 is further disposed on the upper active layer ACL2 of FIG. 14.

Referring further to FIGS. 15 and 16, the third conductive layer CL3 may be disposed on the upper active layer ACL2. For example, the third conductive layer CL3 may be disposed on the fourth insulating layer IL4. The third conductive layer CL3 may include a conductive material such as a metal, an alloy, a conductive metal oxide, a conductive metal nitride, a transparent conductive oxide, or the like. For example, the third conductive layer CL3 may be referred to as a third gate conductive layer.

The third conductive layer CL3 may include first to fifth upper gate patterns UGP1, UGP2, UGP3, UGP4, and UGP5. The first to fifth upper gate patterns UGP1, UGP2, UGP3, UGP4, and UGP5 may be spaced apart from each other in a plan view. The first to fifth upper gate patterns UGP1, UGP2, UGP3, UGP4, and UGP5 may be disposed in the same layer as (or a similar layer to) the second gate electrode GE2 of FIG. 7.

The first upper gate pattern UGP1 may overlap a first portion of the first upper active pattern OACT1 in a plan view. A portion of the first upper gate pattern UGP1 overlapping the first portion of the first upper active pattern OACT1 may form the first transistor T1. The portion of the first upper gate pattern UGP1 overlapping the first portion of the first upper active pattern OACT1 may be a gate electrode of the first transistor T1.

The second upper gate pattern UGP2 may extend in the first direction DR1. The second upper gate pattern UGP2 may overlap a second portion and a third portion of the first upper active pattern OACT1 in a plan view. A first portion of the second upper gate pattern UGP2 overlapping the second portion of the first upper active pattern OACT1 may form the fifth transistor T5. The first portion of the second upper gate pattern UGP2 overlapping the second portion of the first upper active pattern OACT1 may be a gate electrode of the fifth transistor T5. A second portion of the second upper gate pattern UGP2 overlapping the third portion of the first upper active pattern OACT1 may form the sixth transistor T6. The second portion of the second upper gate pattern UGP2 overlapping the third portion of the first upper active pattern OACT1 may be a gate electrode of the sixth transistor T6. The second upper gate pattern UGP2 may receive the first emission control signal EM1. For example, the second upper gate pattern UGP2 may correspond to the first emission control line ECL1 of FIG. 5A.

The third upper gate pattern UGP3 may extend in the first direction DR1. The third upper gate pattern UGP3 may receive the initialization voltage VCINT. For example, the third upper gate pattern UGP3 may correspond to the fourth voltage line VL4 of FIG. 5A. For example, the third upper gate pattern UGP3 may be referred to as a first initialization voltage line.

The fourth upper gate pattern UGP4 may extend in the first direction DR1. The fourth upper gate pattern UGP4 may overlap a first portion of the second upper active pattern OACT2 in a plan view. A portion of the fourth upper gate pattern UGP4 overlapping the first portion of the second upper active pattern OACT2 may form the third transistor T3. The portion of the fourth upper gate pattern UGP4 overlapping the first portion of the second upper active pattern OACT2 may be a gate electrode of the third transistor T3. The fourth upper gate pattern UGP4 may receive the second gate signal GR. For example, the fourth upper gate pattern UGP4 may correspond to the second gate line GRL of FIG. 5A.

The fifth upper gate pattern UGP5 may overlap a second portion of the second upper active pattern OACT2 in a plan view. A portion of the fifth upper gate pattern UGP5 overlapping the second portion of the second upper active pattern OACT2 may form the second transistor T2. The portion of the fifth upper gate pattern UGP5 overlapping the second portion of the second upper active pattern OACT2 may be a gate electrode of the second transistor T2. The fifth upper gate pattern UGP5 may receive the first gate signal GW.

The fifth insulating layer IL5 may be disposed on the fourth insulating layer IL4. The fifth insulating layer IL5 may cover the first to fifth upper gate patterns UGP1, UGP2, UGP3, UGP4, and UGP5 on the fourth insulating layer IL4.

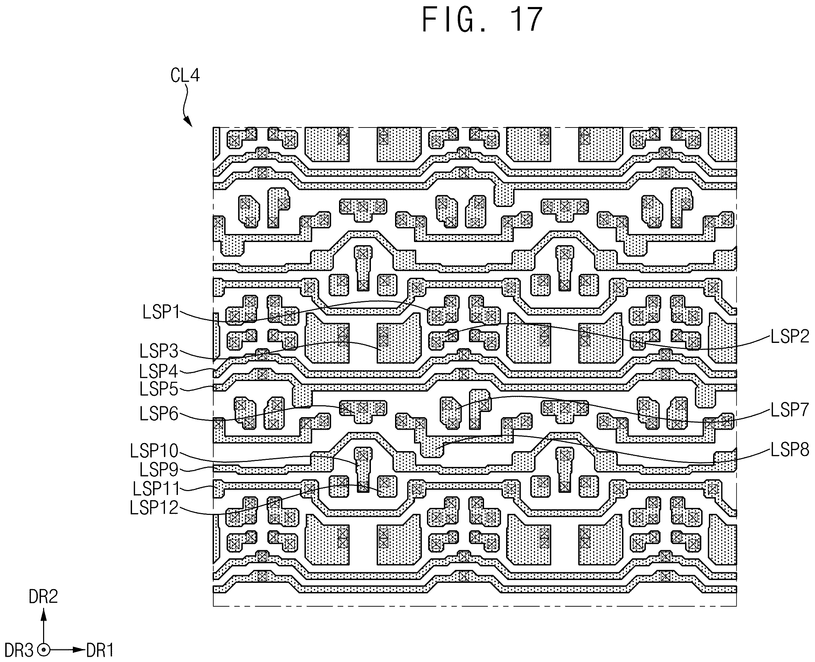

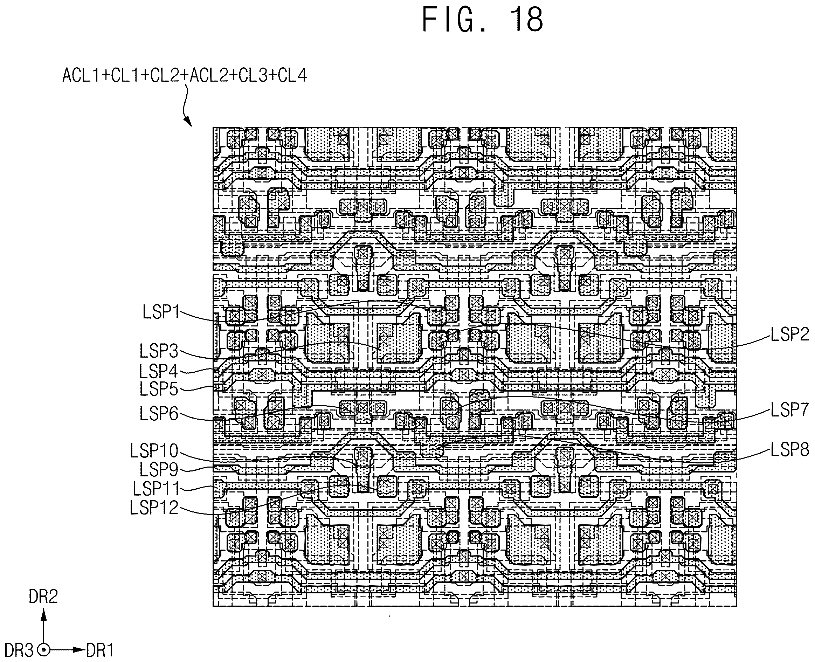

FIG. 17 is a layout view illustrating a fourth conductive layer CL4. FIG. 18 is a layout view in which the fourth conductive layer CL4 is further disposed on the third conductive layer CL3 of FIG. 16.

Referring further to FIGS. 17 and 18, the fourth conductive layer CL4 may be disposed on the third conductive layer CL3. For example, the fourth conductive layer CL4 may be disposed on the fifth insulating layer IL5. The fourth conductive layer CL4 may include a conductive material such as a metal, an alloy, a conductive metal oxide, a conductive metal nitride, a transparent conductive oxide, or the like. For example, the fourth conductive layer CL4 may be referred to as a first source-drain conductive layer.

The fourth conductive layer CL4 may include first to twelfth lower source patterns LSP1, LSP2, LSP3, LSP4, LSP5, LSP6, LSP7, LSP8, LSP9, LSP10, LSP11, and LSP12. The first to twelfth lower source patterns LSP1, LSP2, LSP3, LSP4, LSP5, LSP6, LSP7, LSP8, LSP9, LSP10, LSP11, and LSP12 may be spaced apart from each other in a plan view. The first to twelfth lower source patterns LSP1 , LSP2, LSP3, LSP4, LSP5, LSP6, LSP7, LSP8, LSP9, LSP10, LSP11, and LSP12 may be disposed in the same layer as (or a similar layer to) the first contact electrode SE1 of FIG. 7.

The first lower source pattern LSP1 may overlap the first lower gate pattern LGP1, the first upper gate pattern UGP1, and the first upper active pattern OACT1 in a plan view. The first lower source pattern LSP1 may be connected to the first lower gate pattern LGP1, the first upper gate pattern UGP1, and the first upper active pattern OACT1 through contact holes. Accordingly, the first lower source pattern LSP1 may electrically connect the gate electrode of the first transistor T1, the second transistor T2, and the first capacitor C1.

The second lower source pattern LSP2 may overlap the first lower active pattern PACT1 and the first upper active pattern OACT1 in a plan view. The second lower source pattern LSP2 may be connected to the first lower active pattern PACT1 and the first upper active pattern OACT1 through contact holes. Accordingly, the second lower source pattern LSP2 may electrically connect the first transistor T1 and the seventh transistor T7.

The third lower source pattern LSP3 may overlap the first upper active pattern OACT1 and the first middle gate pattern MGP1 in a plan view. The third lower source pattern LSP3 may be connected to the first upper active pattern OACT1 and the first middle gate pattern MGP1 through contact holes. Accordingly, the third lower source pattern LSP3 may electrically connect the first capacitor C1, the second capacitor C2, and the first transistor T1.

The fourth lower source pattern LSP4 may extend in the first direction DR1. The fourth lower source pattern LSP4 may overlap the second lower gate pattern LGP2 in a plan view. The fourth lower source pattern LSP4 may be connected to the second lower gate pattern LGP2 through a contact hole. The fourth lower source pattern LSP4 may receive the second emission control signal EM2. Accordingly, the fourth lower source pattern LSP4 may provide the second emission control signal EM2 to the second lower gate pattern LGP2. For example, the fourth lower source pattern LSP4 may correspond to the second emission control line ECL2 of FIG. 5A.

The fifth lower source pattern LSP5 may extend in the first direction DR1. The fifth lower source pattern LSP5 may overlap the first lower active pattern PACT1 in a plan view. The fifth lower source pattern LSP5 may be connected to the first lower active pattern PACT1 through a contact hole. The fifth lower source pattern LSP5 may receive the first power voltage ELVDD. Accordingly, the fifth lower source pattern LSP5 may provide the first power voltage ELVDD to the seventh transistor T7. For example, the fifth lower source pattern LSP5 may correspond to the first voltage line VL1 of FIG. 5A. For example, the fifth lower source pattern LSP5 may be referred to as a third driving voltage line.

In some example embodiments, the fifth lower source pattern LSP5 (or the third driving voltage line) may be disposed on the third upper gate pattern UGP3 (or the first initialization voltage line).

The sixth lower source pattern LSP6 may overlap the first upper active pattern OACT1 and the third lower gate pattern LGP3 in a plan view. The sixth lower source pattern LSP6 may be connected to the first upper active pattern OACT1 and the third lower gate pattern LGP3 through contact holes. Accordingly, the sixth lower source pattern LSP6 may electrically connect the first upper active pattern OACT1 and the third lower gate pattern LGP3. The third lower gate pattern LGP3 may provide the second power voltage ELVSS to the sixth transistor T6 through the sixth lower source pattern LSP6.

The seventh lower source pattern LSP7 may overlap the second lower active pattern PACT2 and the first upper active pattern OACT1 in a plan view. The seventh lower source pattern LSP7 may be connected to the second lower active pattern PACT2 and the first upper active pattern OACT1 through contact holes. Accordingly, the seventh lower source pattern LSP7 may electrically connect the fourth transistor T4 and the fifth transistor T5.

The eighth lower source pattern LSP8 may overlap the second lower active pattern PACT2 and the third upper gate pattern UGP3 in a plan view. The eighth lower source pattern LSP8 may be connected to the second lower active pattern PACT2 and the third upper gate pattern UGP3 through contact holes. Accordingly, the eighth lower source pattern LSP8 may electrically connect the second lower active pattern PACT2 and the third upper gate pattern UGP3. The third upper gate pattern UGP3 may provide the initialization voltage VCINT to the fourth transistor T4 through the eighth lower source pattern LSP8. For example, the eighth lower source pattern LSP8 may be referred to as an initialization voltage connection pattern.

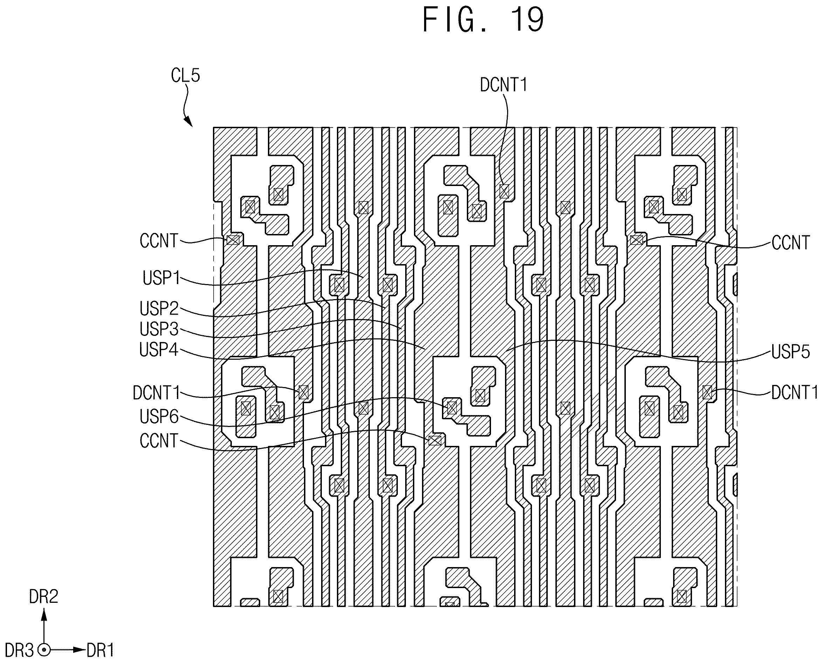

The ninth lower source pattern LSP9 may extend in the first direction DR1. The ninth lower source pattern LSP9 may overlap a third upper source pattern (USP3, see FIG. 19) described below in a plan view.

The tenth lower source pattern LSP10 may overlap the second upper active pattern OACT2 and the second middle gate pattern MGP2 in a plan view. The tenth lower source pattern LSP10 may be connected to the second upper active pattern OACT2 and the second middle gate pattern MGP2 through contact holes. Accordingly, the tenth lower source pattern LSP10 may electrically connect the second upper active pattern OACT2 and the second middle gate pattern MGP2. The second middle gate pattern MGP2 may provide the reference voltage VREF to the third transistor T3 through the tenth lower source pattern LSP10.

The eleventh lower source pattern LSP11 may extend in the first direction DR1. The eleventh lower source pattern LSP11 may overlap the fifth upper gate pattern UGP5 in a plan view. The eleventh lower source pattern LSP11 may be connected to the fifth upper gate pattern UGP5 through a contact hole. The eleventh lower source pattern LSP11 may receive the first gate signal GW. Accordingly, the eleventh lower source pattern LSP11 may provide the first gate signal GW to the fifth upper gate pattern UGP5. For example, the eleventh lower source pattern LSP11 may correspond to the first gate line GWL of FIG. 5A.

The twelfth lower source pattern LSP12 may overlap the second upper active pattern OACT2 in a plan view. The twelfth lower source pattern LSP12 may be connected to the second upper active pattern OACT2 through a contact hole. The twelfth lower source pattern LSP12 may receive the data voltage VDATA. Accordingly, the twelfth lower source pattern LSP12 may provide the data voltage VDATA to the second transistor T2.

The sixth insulating layer IL6 may be disposed on the fifth insulating layer IL5. The sixth insulating layer IL6 may cover the first to twelfth lower source patterns LSP1, LSP2, LSP3, LSP4, LSP5, LSP6, LSP7, LSP8, LSP9, LSP10, LSP11, and LSP12 on the fifth insulating layer IL5.

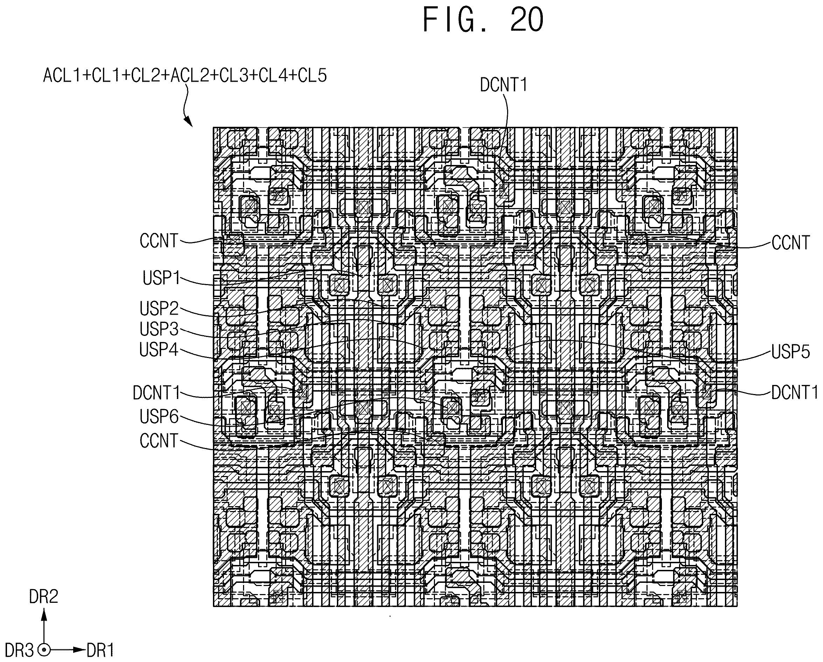

FIG. 19 is a layout view illustrating a fifth conductive layer CL5. FIG. 20 is a layout view in which the fifth conductive layer CL5 is further disposed on the fourth conductive layer CL4 of FIG. 18.

Referring further to FIGS. 19 and 20, the fifth conductive layer CL5 may be disposed on the fourth conductive layer CL4. For example, the fifth conductive layer CL5 may be disposed on the sixth insulating layer IL6. The fifth conductive layer CL5 may include a conductive material such as a metal, an alloy, a conductive metal oxide, a conductive metal nitride, a transparent conductive oxide, or the like. For example, the fifth conductive layer CL5 may be referred to as a second source-drain conductive layer.

The fifth conductive layer CL5 may include first to six upper source patterns USP1, USP2, USP3, USP4, USP5, and USP6. The first to six upper source patterns USP1, USP2, USP3, USP4, USP5, and USP6 may be spaced apart from each other in a plan view. The first to six upper source patterns USP1, USP2, USP3, USP4, USP5, and USP6 may be disposed in the same layer as (or a similar layer to) the first connection electrode CE of FIG. 7.

The first upper source pattern USP1 may extend in the second direction DR2. The first upper source pattern USP1 may overlap the sixth lower source pattern LSP6 in a plan view. The first upper source pattern USP1 may be connected to the sixth lower source pattern LSP6 through a contact hole. The first upper source pattern USP1 may receive the second power voltage ELVSS. Accordingly, the first upper source pattern USP1 may provide the second power voltage ELVSS to the sixth lower source pattern LSP6. For example, the first upper source pattern USP1 may correspond to the second voltage line VL2 of FIG. 5A. For example, the first upper source pattern USP1 may be referred to as a second common voltage line.

In some example embodiments, the third lower gate pattern (LGP3, see FIG. 9) and the first upper source pattern USP1 that receive the second power voltage ELVSS may have a mesh shape in a plan view. The third lower gate pattern LGP3 may extend in the first direction DR1, and the first upper source pattern USP1 may extend in the second direction DR2. Accordingly, a resistance generated in patterns (or lines) that transmit the second power voltage ELVSS may be effectively reduced, and the voltage drop of the second power voltage ELVSS may be effectively prevented (or reduced).

The second upper source pattern USP2 may extend in the second direction DR2. The second upper source pattern USP2 may overlap the twelfth lower source pattern LSP12 in a plan view. The second upper source pattern USP2 may be connected to the twelfth lower source pattern LSP12 through a contact hole. The second upper source pattern USP2 may receive the data voltage VDATA. Accordingly, the second upper source pattern USP2 may provide the data voltage VDATA to the twelfth lower source pattern LSP12. For example, the second upper source pattern USP2 may correspond to the data line DL of FIG. 5A.

The third upper source pattern USP3 may extend in the second direction DR2. The third upper source pattern USP3 may overlap a portion of the ninth lower source pattern LSP9 in a plan view. The third upper source pattern USP3 may be an additional data line for providing the data voltage VDATA to a sub-pixel positioned at an edge portion of the display area (DA, see FIG. 2A).

The fourth upper source pattern USP4 may extend in the second direction DR2. The fourth upper source pattern USP4 may overlap the eighth lower source pattern LSP8 in a plan view. The fourth upper source pattern USP4 may be connected to the eighth lower source pattern LSP8 through an initialization contact hole CCNT. The fourth upper source pattern USP4 may receive the initialization voltage VCINT. Accordingly, the fourth upper source pattern USP4 may provide the initialization voltage VCINT to the eighth lower source pattern LSP8. For example, the fourth upper source pattern USP4 may correspond to the fourth voltage line VL4 of FIG. 5A. For example, the fourth upper source pattern USP4 may be referred to as a second initialization voltage line. According to some example embodiments, the eighth lower source pattern LSP8 may electrically connect the third upper gate pattern UGP3 and the fourth upper source pattern USP4.

In some example embodiments, the third upper gate pattern (UGP3, see FIG. 15) and the fourth upper source pattern USP4 that receive the initialization voltage VCINT may have a mesh shape in a plan view. The third upper gate pattern UGP3 may extend in the first direction DR1, and the fourth upper source pattern USP4 may extend in the second direction DR2. Accordingly, a resistance generated in patterns (or lines) that transmit the initialization voltage VCINT may be effectively reduced. As a result, a luminance difference between pixels due to the resistance may be reduced, a defect in which a stain is recognized in the display device DD may be effectively prevented (or reduced), and the display quality of the display device DD may be improved.

The fifth upper source pattern USP5 may extend in the second direction DR2. The fifth upper source pattern USP5 may overlap the fifth lower source pattern LSP5 in a plan view. The fifth upper source pattern USP5 may be connected to the fifth lower source pattern LSP5 through a first driving contact hole DCNT1. The fifth upper source pattern USP5 may receive the first power voltage ELVDD. Accordingly, the fifth upper source pattern USP5 may provide the first power voltage ELVDD to the fifth lower source pattern LSP5. For example, the fifth upper source pattern USP5 may correspond to the first voltage line VL1 of FIG. 5A. For example, the fifth upper source pattern USP5 may be referred to as a fourth driving voltage line.

In some example embodiments, the fifth lower source pattern (LSP5, see FIG. 17) and the fifth upper source pattern USP5 that receive the first power voltage ELVDD may have a first mesh shape in a plan view. The fifth lower source pattern LSP5 may extend in the first direction DR1, and the fifth upper source pattern USP5 may extend in the second direction DR2.

In some example embodiments, the first driving contact hole DCNT1 and the initialization contact hole CCNT may be spaced apart from each other in a plan view.

In some example embodiments, the first driving contact hole DCNT1 and the initialization contact hole CCNT may be alternately arranged along one direction in a plan view. For example, the first driving contact hole DCNT1 and the initialization contact hole CCNT may be arranged in an order of the initialization contact hole CCNT, the first driving contact hole DCNT1, the initialization contact hole CCNT, and the first driving contact hole DCNT1 along the first direction DR1. For example, the first driving contact hole DCNT1 and the initialization contact hole CCNT may be arranged in an order of the first driving contact hole DCNT1, the initialization contact hole CCNT, the first driving contact hole DCNT1, and the initialization contact hole CCNT along an opposite direction of the second direction DR2. However, the present disclosure is not necessarily limited thereto.

The sixth upper source pattern USP6 may overlap the seventh lower source pattern LSP7 in a plan view. The sixth upper source pattern USP6 may be connected to the seventh lower source pattern LSP7 through a contact hole. The sixth upper source pattern USP6 may electrically connect the seventh lower source pattern LSP7 and any one of the connection patterns CNPa, CNPb, and CNPc of FIG. 6.

The seventh insulating layer IL7 may be disposed on the sixth insulating layer IL6. The seventh insulating layer IL7 may cover the first to six upper source patterns USP1, USP2, USP3, USP4, USP5, and USP6 on the sixth insulating layer IL6.

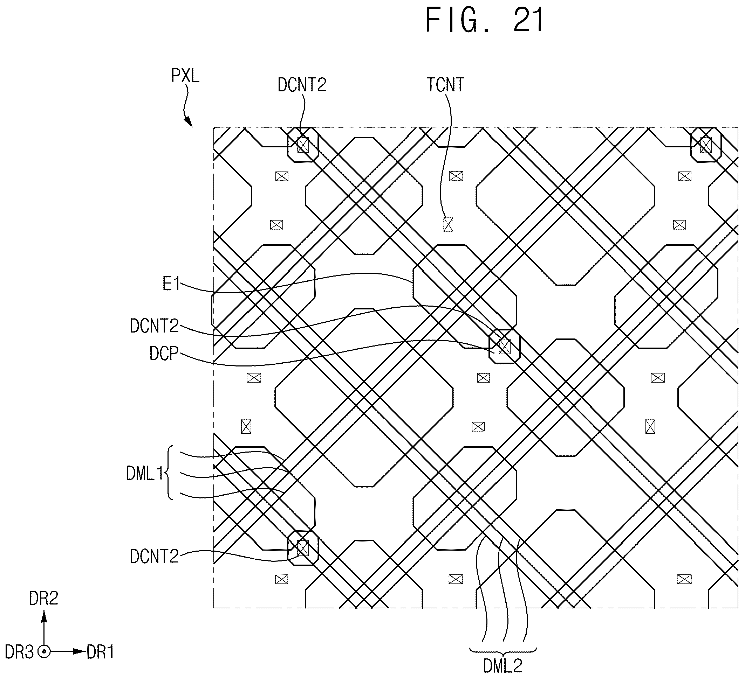

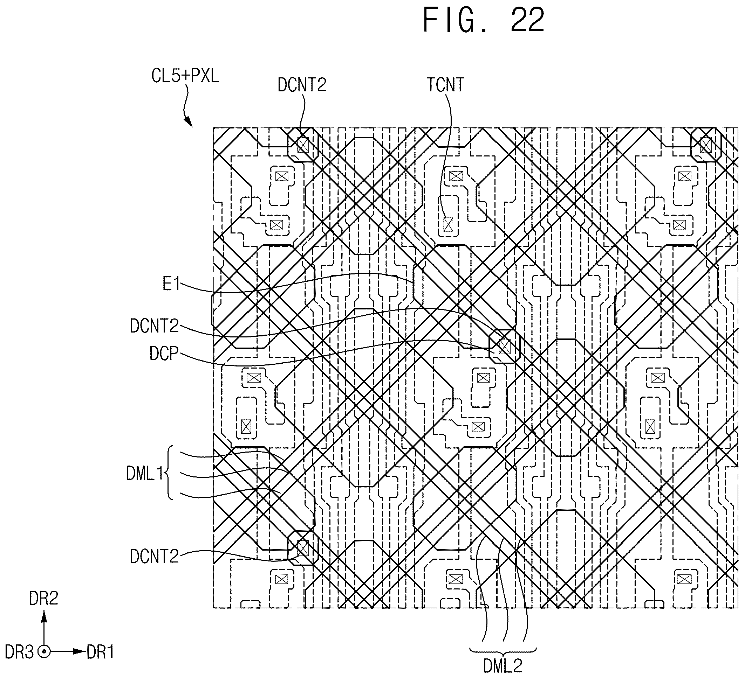

FIG. 21 is a layout view illustrating a pixel layer PXL in which the first electrode E1 of FIG. 7 is disposed. FIG. 22 is a layout view in which the pixel layer PXL of FIG. 21 is further disposed on the fifth conductive layer CL5 of FIG. 19.

Referring further to FIGS. 21 and 22, the pixel layer PXL may be disposed on the fifth conductive layer CL5. For example, the pixel layer PXL may be disposed on the seventh insulating layer IL7. The pixel layer PXL may include a conductive material such as a metal, an alloy, a conductive metal oxide, a conductive metal nitride, a transparent conductive oxide, or the like.

The pixel layer PXL may include the first electrode E1, a first driving voltage line DML1, a second driving voltage line DML2, and a driving voltage connection pattern DCP. In some example embodiments, the first electrode E1, the first driving voltage line DML1, the second driving voltage line DML2, and the driving voltage connection pattern DCP may be integrally formed.

The first electrode E1 of FIG. 21 may correspond to the first electrode E1 of FIG. 7. That is, the first electrode E1 may function as the anode of the light-emitting element LD of FIG. 5A.

The first driving voltage line DML1 may extend in a first diagonal direction between the first direction DR1 and the second direction DR2. That is, the first diagonal direction in which the first driving voltage line DML1 extends may be different from the first direction DR1 in which the third upper gate pattern UGP3 (or the first initialization voltage line) extends and the second direction DR2 in which the fourth upper source pattern USP4 (or the second initialization voltage line) extends. In addition, the first diagonal direction in which the first driving voltage line DML1 extends may be different from the first direction DR1 in which the fifth lower source pattern LSP5 (or the third driving voltage line) extends and the second direction DR2 in which the fifth upper source pattern USP5 (or the fourth driving voltage line) extends. The first driving voltage line DML1 may overlap the first electrode E1. The first driving voltage line DML1 may receive the first power voltage ELVDD.

The second driving voltage line DML2 may extend in a second diagonal direction between an opposite direction of the first direction DR1 and the second direction DR2. The second diagonal direction may intersect the first diagonal direction. For example, the first diagonal direction and the second diagonal direction may be perpendicular. That is, the second diagonal direction in which the second driving voltage line DML2 extends may be different from the first direction DR1 in which the third upper gate pattern UGP3 (or the first initialization voltage line) extends and the second direction DR2 in which the fourth upper source pattern USP4 (or the second initialization voltage line) extends. In addition, the second diagonal direction in which the second driving voltage line DML2 extends may be different from the first direction DR1 in which the fifth lower source pattern LSP5 (or the third driving voltage line) extends and the second direction DR2 in which the fifth upper source pattern USP5 (or the fourth driving voltage line) extends. The second driving voltage line DML2 may overlap the first electrode E1. The second driving voltage line DML2 may receive the first power voltage ELVDD.

As illustrated in FIG. 21, the driving voltage connection pattern DCP may overlap the second driving voltage line DML2. However, the present disclosure is not necessarily limited thereto, and the driving voltage connection pattern DCP may overlap the first driving voltage line DML1. The driving voltage connection pattern DCP may overlap the fifth upper source pattern USP5 in a plan view. The driving voltage connection pattern DCP may be connected to the fifth upper source pattern USP5 through a second driving contact hole DCNT2. In some example embodiments, the second driving contact hole DCNT2 may be spaced apart from the first driving contact hole DCNT1 of FIG. 19 in a plan view. The driving voltage connection pattern DCP may electrically connect the fifth upper source pattern USP5 and the second driving voltage line DML2 (or the first driving voltage line DML1).

A pattern contact hole TCNT of FIG. 21 may correspond to any one of the first to third pattern contact holes TCNTa, TCNTb, and TCNTc of FIG. 6. In some example embodiments, the pattern contact hole TCNT and the second driving contact hole DCNT2 may be spaced apart from each other in a plan view.

In some example embodiments, the first driving voltage line DML1 and the second driving voltage line DML2 that receive the first power voltage ELVDD may have a second mesh shape in a plan view. The first driving voltage line DML1 may extend in the first diagonal direction, and the second driving voltage line DML2 may extend in the second diagonal direction.

As described above, the fifth lower source pattern LSP5 and the fifth upper source pattern USP5 that receive the first power voltage ELVDD may have the first mesh shape in a plan view, and the first driving voltage line DML1 and the second driving voltage line DML2 that receive the first power voltage ELVDD may have the second mesh shape in a plan view. That is, lines (or patterns) that transmit the first power voltage ELVDD may have a double mesh shape in a plan view. Accordingly, a resistance generated in the lines (or the patterns) that transmit the first power voltage ELVDD may be effectively reduced, and the voltage drop of the first power voltage ELVDD may be effectively prevented (or reduced).

FIG. 23 is a block diagram illustrating an electronic device according to some example embodiments of the present disclosure.

Referring to FIG. 23, an electronic device 10 according to some example embodiments may include a display module 11, a processor 12, a memory 13, and/or a power module 14. The display device according to some example embodiments may be applied to a variety of electronic devices. The electronic device 10 according to some example embodiments may include the display device described above, and may further include modules or devices having other additional functions in addition to the display device. According to some example embodiments, operations described herein as being performed by the electronic device 10, the display module 11, the processor 12, and/or the power module 14 may be performed by processing circuitry.

The processor 12 may include at least one of a central processing unit (CPU), an application processor (AP), a graphic processing unit (GPU), a communication processor (CP), an image signal processor (ISP), and/or a controller.

The memory 13 may store data information required (or otherwise, used) for operation of the processor 12 and/or the display module 11. When the processor 12 executes an application stored in the memory 13, an image data signal and/or an input control signal may be transmitted to the display module 11, and the display module 11 may process the received signals and may output image information through a display screen.

The power module 14 may include a power supply module, such as a power adapter or a battery device, etc., and a power conversion module that converts power supplied by the power supply module to generate the power required (or otherwise, used) for operation of the electronic device 10. That is, the power module 14 may provide power to the display device according to the examples described above.

At least one of the components of the electronic device 10 described above may be included in the display device according to the examples described above. In addition, some of the individual modules that are functionally included in one module may be included in the display device and others may be provided separately from the display device. For example, the display device may include the display module 11, and the processor 12, the memory 13, and/or the power module 14 may be provided in the form of other devices in the electronic device 10 other than the display device.

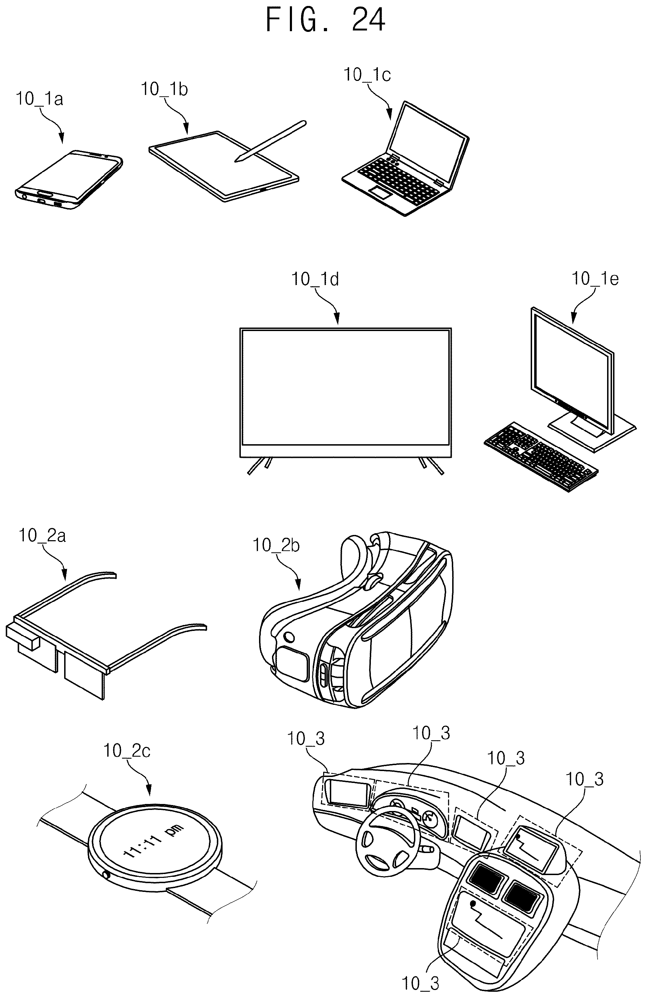

FIG. 24 is a schematic view of an electronic device according to some example embodiments.

Referring to FIG. 24, various electronic devices to which a display device according to some example embodiments is applied may include image display electronic devices such as a smartphones 10_1a, a tablet PC 10_1b, a laptop 10_1c, a television 10_1d, a desk monitor 10_1e, or the like, wearable electronic devices including display modules such as a smart glasses 10_2a, a head-mounted display 10_2b, a smart watch 10_2c, or the like, and vehicle electronic devices 10_3 including display modules such as a CID (center information display) which may be disposed on a instrument panel, a center fascia, and a dashboard of an automobile and a room mirror display, or the like.

The various operations of methods described above may be performed by any suitable device capable of performing the operations, such as the processing circuitry discussed above. For example, as discussed above, the operations of methods described above may be performed by various hardware and/or software implemented in some form of hardware (e.g., processor, ASIC, etc.).

The software may comprise an ordered listing of executable instructions for implementing logical functions, and may be embodied in any "processor-readable medium" for use by or in connection with an instruction execution system, apparatus, or device, such as a single or multiple-core processor or processor-containing system.

The blocks or operations of a method or algorithm, and/or functions, described in connection with some example embodiments disclosed herein may be embodied directly in hardware, in a software module executed by a processor, or in a combination of the two. If implemented in software, the functions may be stored on or transmitted over as one or more instructions or code on a tangible, non-transitory computer-readable medium. A software module may reside in Random Access Memory (RAM), flash memory, Read Only Memory (ROM), Electrically Programmable ROM (EPROM), Electrically Erasable Programmable ROM (EEPROM), registers, hard disk, a removable disk, a CD ROM, or any other form of storage medium known in the art.

The present disclosure may be applied to various display devices. For example, the present disclosure is applicable to various display devices such as display devices for vehicles, ships and aircraft, portable communication devices, display devices for exhibition or information transmission, medical display devices, and the like.

The foregoing is illustrative of some example embodiments of the present disclosure, and is not to be construed as limiting thereof. Although some example embodiments have been described with reference to the figures, those skilled in the art will readily appreciate that many variations and modifications may be made therein without departing from the scope of the present disclosure as defined in the appended claims.

## Claims

1. A display device, comprising:
a substrate (SUB);
a pixel driving circuit (PC, PC', PC') on the substrate, the pixel driving circuit including a transistor;
a connection electrode (CE) on the substrate, the connection electrode being electrically connected to the pixel driving circuit;
a first electrode (E1) on the substrate, the first electrode being spaced apart from the connection electrode;
a pixel defining layer (PDL) on the substrate, the pixel defining layer defining an opening exposing a portion of the first electrode;
an electrode layer (E2L) on the first electrode, the electrode layer being electrically connected to the connection electrode;
a first driving voltage line (DML1) in a same layer as the first electrode, the first driving voltage line being configured to receive a first power voltage, and the first driving voltage line extending in a first direction; and
a second driving voltage line (DML2) in the same layer as the first electrode, the second driving voltage line being configured to receive the first power voltage, and the second driving voltage line extending in a second direction intersecting the first direction.

2. The display device of claim 1, wherein the first driving voltage line (DML1) and the second driving voltage line (DML2) have a mesh shape in a plan view.

3. The display device of claim 1 or 2, further comprising:
a third driving voltage line (DML3) between the substrate and the first electrode, the third driving voltage line being configured to receive the first power voltage; and
a fourth driving voltage line (DML4) between the third driving voltage line and the first electrode, the fourth driving voltage line being configured to receive the first power voltage.

4. The display device of claim 3, wherein the third driving voltage line (DML3) and the fourth driving voltage line (DML4) have a mesh shape in a plan view.

5. The display device of any of the preceding claims, further comprising:
a separator (SPR) on the pixel defining layer, the separator being configured to separate the electrode layer into a plurality of second electrodes spaced apart from each other; and
a connection pattern (CNPa, CNPb, and CNPc) on the connection electrode (CE) and the pixel defining layer, the connection pattern being connected to the connection electrode (CE).

6. The display device of claim 5, wherein the connection pattern is connected to one of the plurality of second electrodes at a position adjacent to or overlapping the separator.

7. The display device of claim 5 or 6, further comprising:
a driving voltage connection pattern (DCP) in the same layer as the first electrode, the driving voltage connection pattern (DCP) electrically connecting the first driving voltage line (DML1) and the fourth driving voltage line (DML4), and/or wherein
the connection pattern is connected to the connection electrode through a pattern contact hole;
the driving voltage connection pattern is connected to the fourth driving voltage line (DML4) through a driving contact hole (DCNT1, DCNT2); and
the pattern contact hole and the driving contact hole are spaced apart from each other in a plan view.

8. The display device of any of the preceding claims, wherein the pixel driving circuit further comprises:
a lower active pattern (PACT) on the substrate;
a first gate electrode (GE1) on the lower active pattern; and
a contact electrode on the first gate electrode, and/or wherein
the third driving voltage line (DML3) and the contact electrode are in a same layer; and
the fourth driving voltage line (DML4) and the connection electrode are in a same layer.

9. The display device of any of the preceding claims, wherein the first driving voltage line (DML1), the second driving voltage line (DML2), and the first electrode are integrally formed.

10. The display device of any of the preceding claims, further comprising:
a first initialization voltage line (UGP3) between the substrate and the first electrode, the first initialization voltage line being configured to receive an initialization voltage, and the first initialization voltage line extending in a third direction (D1);
a second initialization voltage line (UGP4) between the first initialization voltage line and the first electrode, the second initialization voltage line being configured to receive the initialization voltage, and the second initialization voltage line extending in a fourth direction (D2) intersecting the first direction;
wherein the first driving voltage line (DML1) extending in the first direction between the third direction and the fourth direction

11. The display device of claim 10, wherein
the first initialization voltage line (UGP3) and the second initialization voltage line (UGP4) have a mesh shape in the plan view.

12. The display device of claim 10 or 11, further comprising:
an initialization voltage connection pattern (LSP8) electrically connecting the first initialization voltage line and the second initialization voltage line,
wherein
the fourth driving voltage line (DML4) is connected to the third driving voltage line (DML3) through a first driving contact hole (DCNT1),
the second initialization voltage line is connected to the initialization voltage connection pattern through an initialization contact hole (CCNT), and
the first driving contact hole and the initialization contact hole are spaced apart from each other in a plan view.

13. The display device of claim 12, wherein the first driving contact hole (DCNT1) and the initialization contact hole (CCNT) are alternately arranged along one direction in the plan view.

14. The display device of any of claims 10 to 13, wherein
the third driving voltage line (DML3) is on the first initialization voltage line (UGP3), and
the fourth driving voltage line (DML4) and the second initialization voltage line (UGP4) are in a same layer, and/or wherein the first driving voltage line (DML1), the second driving voltage line (DML2), and the first electrode are integrally formed.

15. An electronic device (10) comprising:
a display device of any of the preceding claims; and
processing circuitry configured to transmit an image data signal and an input control signal to the display device.
